**Europäisches Patentamt**

**European Patent Office**

**Office européen des brevets**

(19)

(11) **EP 1 610 466 A1**

(12) **EUROPEAN PATENT APPLICATION**

(43) Date of publication:
**28.12.2005 Bulletin 2005/52**

(51) Int Cl.[7]: **H03M 13/11**, H04L 1/00

(21) Application number: **05012044.3**

(22) Date of filing: **03.06.2005**

(84) Designated Contracting States:
**AT BE BG CH CY CZ DE DK EE ES FI FR GB GR
HU IE IS IT LI LT LU MC NL PL PT RO SE SI SK TR**
Designated Extension States:
**AL BA HR LV MK YU**

(30) Priority: **22.06.2004 US 581677 P
18.02.2005 US 61232**

(71) Applicant: **Infineon Technologies AG
81669 München (DE)**

(72) Inventors:
• **Litsyn, Simon
  54423 - Givat Shmuel Israel (IL)**
• **Sharon, Eran
  75493 - Rishon-Lezion (IL)**

(74) Representative:
**Reinhard - Skuhra - Weise & Partner
Postfach 44 01 51
80750 München (DE)**

(54) **LDPC decoder for decoding a low-density parity check (LDPC) codewords**

(57)   LDPC decoder which comprises:

(a) a memory (3) for storing for each codeword bit of the received noisy codeword (Y) a priori estimates (Qv) that said codeword bit has a predetermined value from the received noisy codeword (Y) and from predetermined parameters of the communication channel;

(b) generalized check node processing units (5) for calculating iteratively messages on all edges of said bipartite graph according to a serial schedule wherein in each iteration, for each check node (C) of said bipartite graph, for all neighboring variable nodes (V) connected to said check node (C) input messages ($Q_{VC}$) to said check node (C) from said neighboring variable nodes (V) and output messages ($R_{CV}$) from the check node (C) to said neighboring variable nodes (V) are calculated by means of a message passing computation rule.

FIG 15B   Efficient Message-Passing decoder architecture based on serial scheduling

**Description**

This invention refers to the field of data communication and is in particular directed to redundant coding for error correction and detection.

Low-density parity check codes (LDPC) are a class of linear block codes which provide a near capacity performance on a large collection of data transmission and storage channels while simultaneously admitting implementable encoding and decoding schemes. LDPC codes were first proposed by Gallager in his 1960 doctor dissertation (R. Gallager: "Low-density parity check codes", IRE transformation series pp 21-28, January 1962). From practical point of view, the most significant features of Gallager's work have been the introduction of iterative decoding algorithms for which he showed that, when applied to sparse parity check matrices, they are capable of achieving a significant fraction of the channel capacity with relatively low complexity.

LDPC codes are defined using sparse parity-check matrices comprising of a small number of non-zero entries. To each parity check matrix H exists a corresponding bipartite Tanner graph having variable nodes (V) and check nodes (C). A check node C is connected to a variable node V when the element $h_{ij}$ of the parity check matrix H is 1. The parity check matrix H comprises M rows and N columns. The number of columns N corresponds to the number N of codeword bits within one encoded codeword b. The codeword comprises K information bits and M parity check bits. The number of rows within the parity check matrix H corresponds to the number M of parity check bits in the codeword. In the corresponding Tanner graph there are M=N-K check nodes C, one check node for each check equation, and N variable nodes, one for each codebit of the codeword.

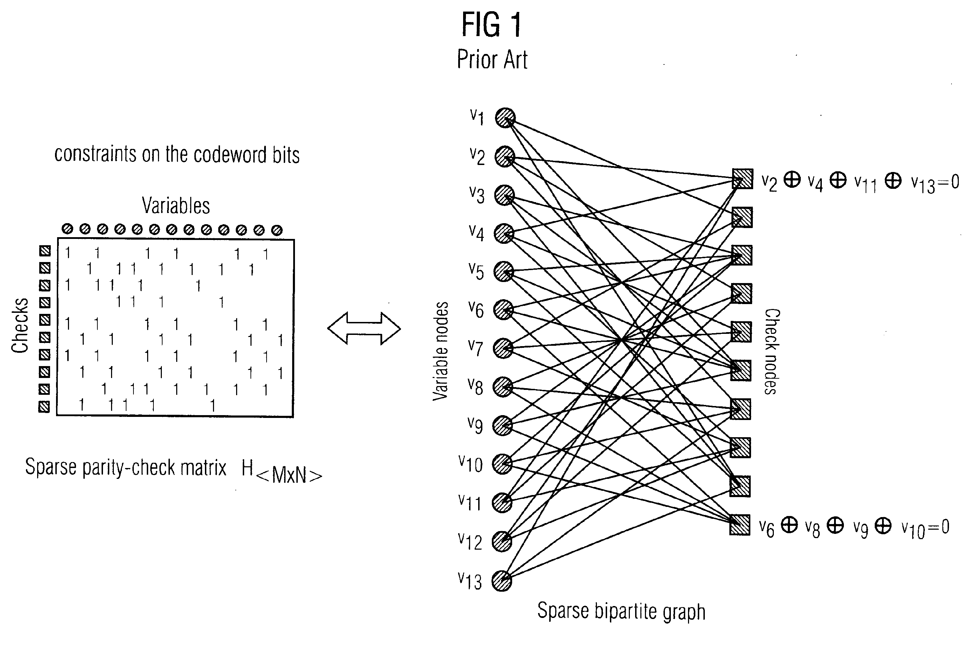

Figure 1 shows an example for a sparse parity check matrix H and the corresponding bipartite Tanner graph.

A regular $(d_v,d_c)$-LDPC code is defined using a regular bipartite graph. Each left side node (called variable node and denoted by v) emanates $d_v$ edges to each of the parity-checks that the corresponding bits participate in. Each right side node (called check node and denoted by c) emanates $d_c$ edges to each of the variable nodes v that participate in the corresponding parity-check.

Thus, there are $N*d_v = M*d_c$ edges in the bipartite graph and the design rate R of the LDPC code is given by :

$$R = K/N = 1- \frac{d_v}{d_c}.$$

The actual rate R of a given LDPC code from the ensemble of regular $(d_v, d_c)$-LDPC codes may be higher since the parity-checks may be dependent.

Regular LDPC codes can be generalized to irregular LDPC codes that exhibit better performance than the regular LDPC codes. An $(\lambda(\chi),\rho(\chi))$-irregular LDPC code is represented by an irregular bipartide graph, where the degree of each left and right node can be different. The ensemble of irregular LDPC codes is defined by the left and right degree distributions.

With

$$\lambda(x) = \sum_{i=2}^{d_v} \lambda_i x^{i-1} \text{ and } \rho(x) = \sum_{i=2}^{d_c} \rho_i x^{i-1}$$

being the generating functions of the degree distributions for the variable and check nodes respectively, wherein $\lambda_i$ and $\rho_i$ are the fractions of edges belonging to degree-i variable node v and check node c respectively, and $d_v$ and $d_c$ being the maximal left and right degrees respectively then, the designed rate R of the LDPC-code is given by :

$$R = 1 - \frac{\int_0^1 \rho(x)dx}{\int_0^1 \lambda(x)dx}.$$

The degree distributions can be optimized in order to generate a capacity approaching LDPC-code.

LDPC codes have the ability to achieve a significant fraction of the channel capacity at relatively low complexity using iterative message passing decoding algorithms. These algorithms are based on the Tanner graph representation of codes, where the decoding can be understood as message passing between variable nodes V and check nodes C in the Tanner graph as shown in figure 1.

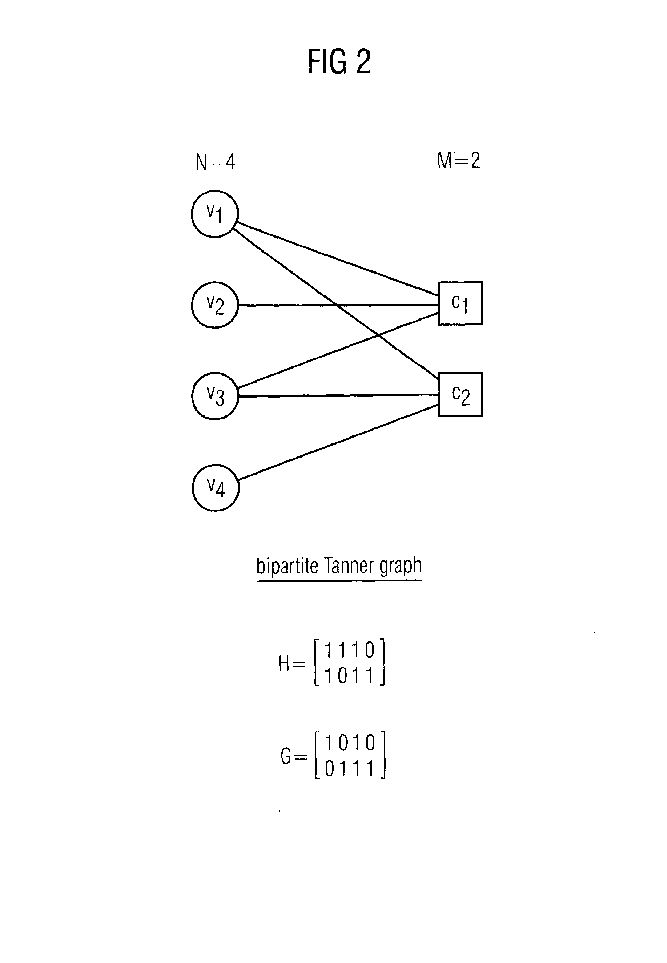

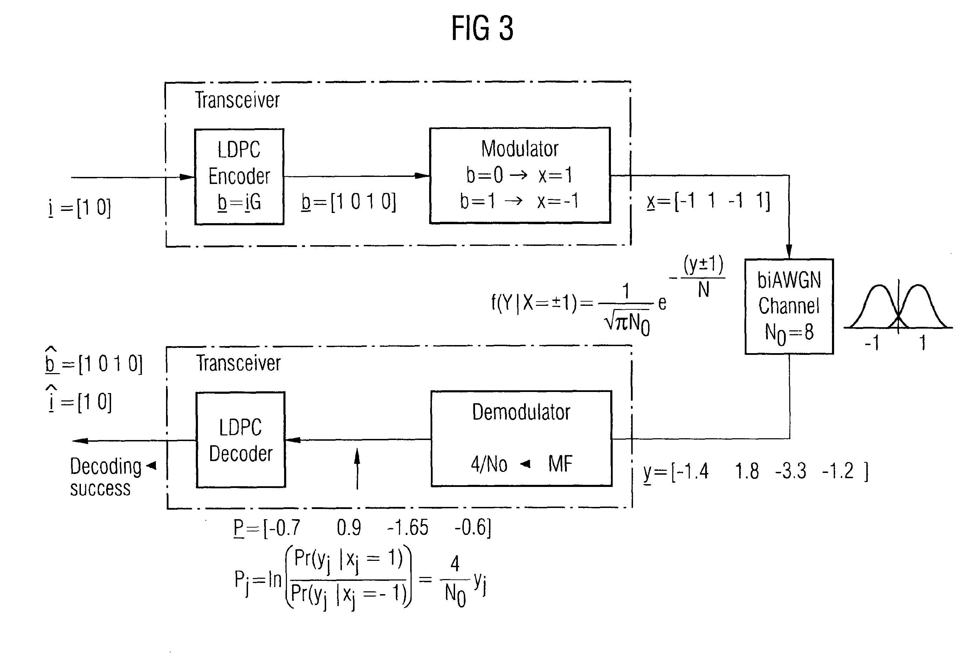

How LDPC codes and their message-passing decoding algorithms work is best demonstrated with a simple example as shown in figure 2, 3.

Figure 2 shows a simple Tanner graph for an LDPC code having four variable nodes $V_1$, $V_2$, $V_3$, $V_4$ and two check or constraint nodes $C_1$, $C_2$. Accordingly the block length of the codeword N=4 and the number of parity checkbits M=2. Consequently the number of information bits k is N-M=2.

The code rate R which is defined as the ratio between the number k of information bits and the block length N (R=k/N) is in this example ½.

The parity check matrix H corresponding to the bipartite Tanner graph is shown in figure 2.

For the LDPC code there exists a generator matrix G such that:

$$(1)$$

$$G \cdot H^T = \varnothing$$

i.e. a product of the generator matrix G and the transposed corresponding parity check matrix $H^T$ is zero.

Figure 3 shows two transceivers which are connected via the Additive White Gaussian Noise (AWGN) Channel. LDPC codes can be applied for any possible communication channel. During data transmission the communication channel corrupts the transmitted codeword so that a one become zero or vice versa. To diminish the bit error rate BER the transmitting transceiver comprises as shown in figure 3 an LDCP-encoder which multiplies an information bit vector i having K=2 information bits with the generator matrix G of the LDPC code. In the example of figure 2 the LDPC-encoder outputs an encoded bit vector $\underline{b}$ which is modulated by a modulator within the transceiver. In the given example the modulator transforms a low logical value zero of the coded bit vector $\underline{b}$ to a transmission bit X=1 and a logically high value of the encoded bit vector $\underline{b}$ is transformed to X=-1. The transmitting transceiver transmits the modulated codeword $\underline{X}$ via the communication channel to the receiving transceiver as shown in figure 3. In the given example the communication channel is a binary input AWGN channel with a single sided spectral noise density NØ = 8.

The receiving transceiver receives a codeword Y from the communication channel having N values.

The codeword Y is formed by adding noise to the transmission vector X :

$$(2)$$

$$Y = X + Noise$$

The received codeword Y is demodulated and log-likelihood ratios (LLR) of the received codeword bits are calculated. For a binary input AWGN channel the log-likelihood ratios LLR are calculated as following :

$$(3)$$

$$P_j = \ln\left(\frac{\Pr\left(y_j / x_j = 1\right)}{\Pr\left(y_j / x_j = -1\right)}\right) = \frac{4}{N_0} Y_j$$

Figure 3 shows the log-likelihood ratios for $N_0$=8, where each received codeword value is divided by two. The log-likelihood ratios LLR give an a-priori estimate that a received codeword bit has a predetermined value.

The estimates are forwarded to the LDPC decoder within the transceiver which performs the LDPC decoding process.

A conventional LDPC decoder employs a standard message passing schedule for decoding the LDPC code which is called a flooding schedule as described in R. Gallager: "Low-density parity check codes", IRE transformation series pp 21-28, January 1962

A schedule is an updating rule which indicates the order of passing the messages between the nodes of the Tanner graph. A conventional LDPC decoder according to the state of the art employs a message passing procedure such as a belief propagation algorithm BP based on a flooding schedule.

Figure 4 shows a flowchart of a belief propagation BP procedure employing a flooding schedule according to the state of the art.

Figure 5 shows a belief propagation BP decoding process using the standard flooding procedure as shown in figure 4 with the example of figure 3.

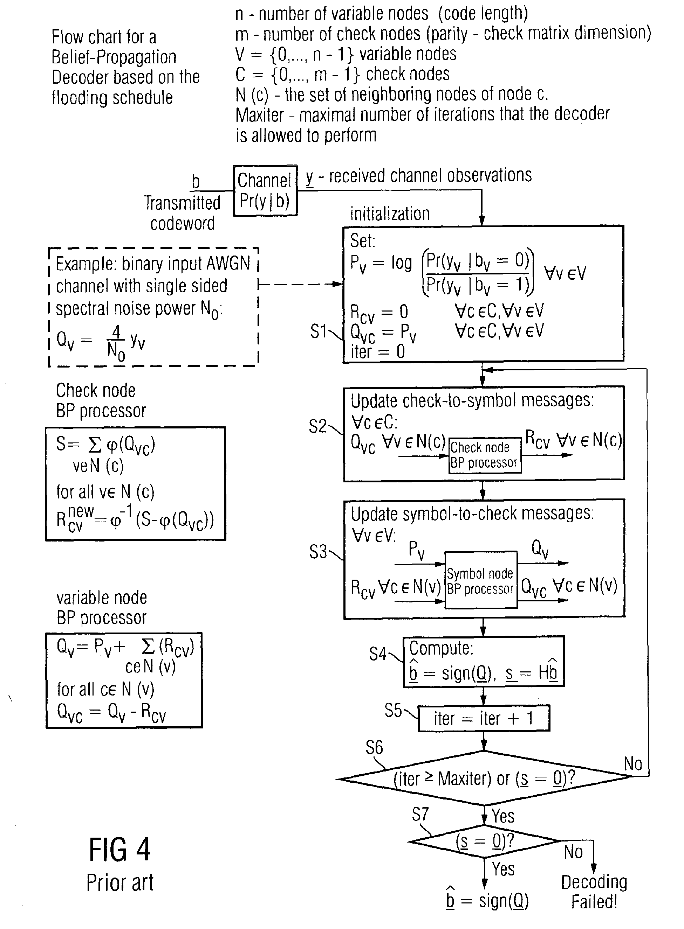

As can be seen in figure 4 the received codeword Y is demodulated and log-likelihood ratios LLR are calculated.

In an initialization step S1 the messages $R_{CV}$ from the check nodes C to the variable nodes V are set to zero for all check nodes and for all variable nodes. Further the messages $Q_{VC}$ from the variable nodes to the check nodes within the Tanner graphs are initialized with the calculated a-priori estimates Pv or log-likelihood ratios.

Further as shown in figure 4 an iteration counter iter is set to zero.

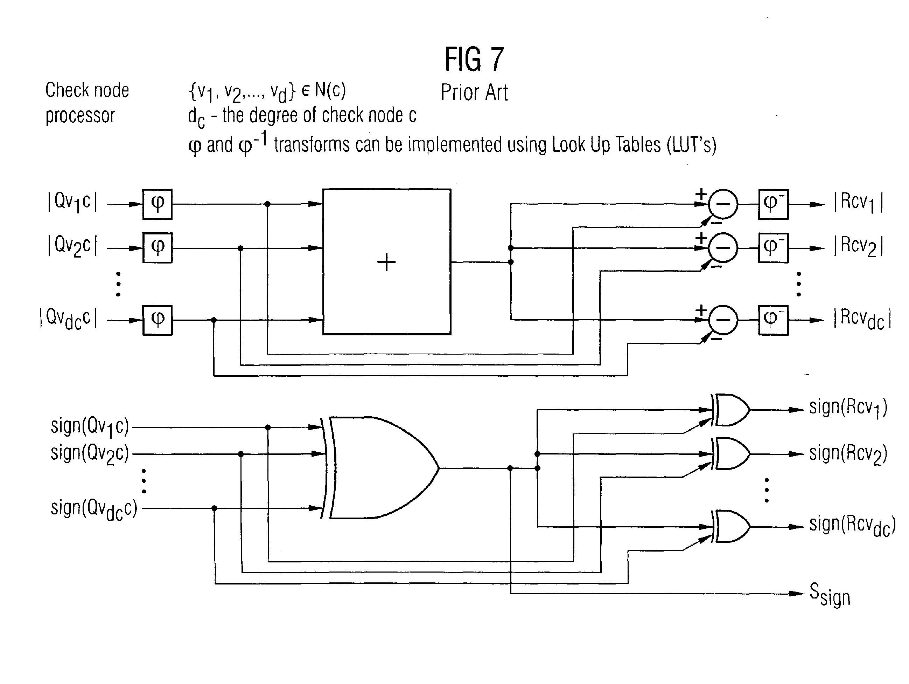

In a step S2 the messages $R_{CV}$ from the check nodes to the variable nodes QVC are updated. The calculation is performed by a check node processor as shown in figure 7.

The calculation performed by the check node processor can be described as follows :

$$(4)$$

$$S = \sum_{v \in N(c)} \varphi(Q_{vc})$$

for all $v \in N(c)$ :

$$R_{cv}^{new} = \varphi^{-1}(S - \varphi(Q_{vc}))$$

*wherein*

$$\varphi(x) = \left( sign(x), -\log \tanh\left(\frac{|x|}{2}\right) \right)$$

$$\varphi^{-1}(x) = (-1)^{sign}\left( -\log\left[ \tanh\left(\frac{x}{2}\right) \right] \right)$$

*wherein the sign function is defined as* :

$$sign(x) = \begin{cases} 0 & x \geq 0 \\ 1 & x < 0 \end{cases}$$

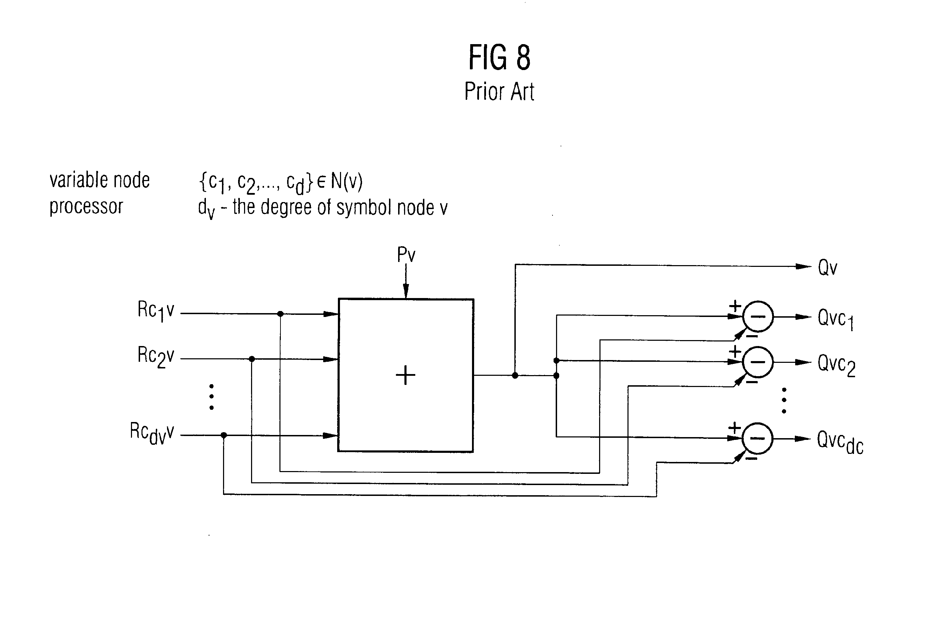

In a step S3 the messages $Q_{VC}$ from the variable nodes V to the check nodes C are updated by a variable node processor as shown in figure 8.

The updating of the variable to check messages $Q_{VC}$ can be described as follows:

$$(5)$$

$$Q_V = P_V + \sum_{C \in N(v)} R_{CV}$$

$$for \ all \ C \in N(v)$$

$$Q_{VC} = Q_V - R_{CV}$$

In a step S4 an estimate vector $\hat{b}$ is calculated from $Q_V$ according to the definition of the sign function and a syndrome vector S is calculated by multiplying the parity check matrix H with the calculated estimate vector $\underline{b}$ :

$$(6)$$

$$\hat{\underline{b}} = sign(Q)$$

$$\underline{s} = H \cdot \hat{\underline{b}}$$

In a step S5 the iteration counter iter is incremented.

In a step S6 it is checked whether the iteration counter has reached a predefined maximum iteration value, i.e. a threshold value or whether the syndrome vector S is zero. If the result of the check in step S6 is NO the procedure continues with the next iteration.

In contrast if the result of the check in step S6 is positive it is checked in step S7 whether the syndrome vector S is zero or not. If the syndrome vector S is not zero the iteration has been stopped because the maximum number of iterations has been reached which is interpreted as a decoding failure. Accordingly the LDPC decoder outputs a signal indicating the decoding failure. On the other hand, if the syndrome vector S is zero then decoding is successful, i.e. the decoding process has converged. In this case the LDPC decoder outputs the last calculated estimated vector $\underline{b}$ as the correct decoded codeword.

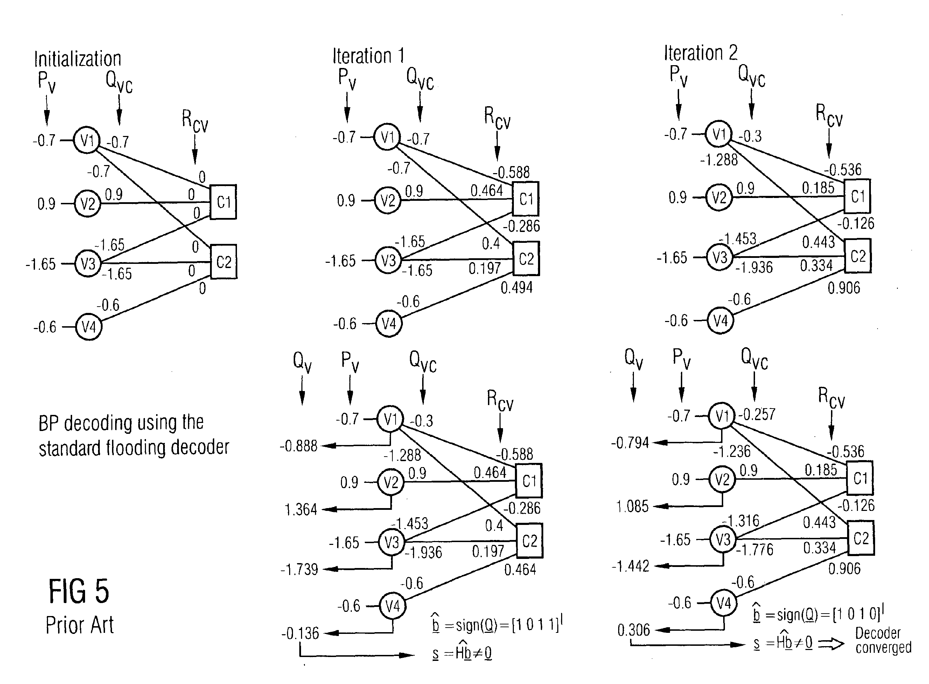

Figure 5 shows the calculated check to variable messages $R_{CV}$ and variable to check messages $Q_{VC}$ after each iteration until convergence of the decoder.

For the given example of figure 3 the LDPC decoder of the receiving transceiver outputs the estimate vector $\underline{b} = (1010)^T$ and indicates that the decoding was performed successfully. Note that the decoded estimate vector $\underline{b}$ corresponds to the output of the LDPC encoder within the transmitting transceiver.

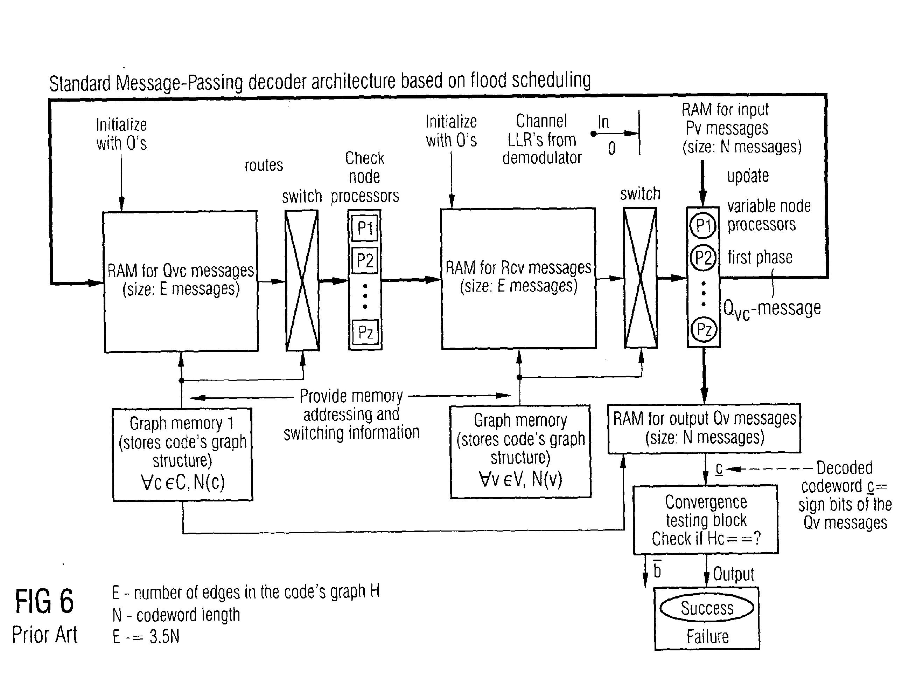

Figure 6 shows a block diagram of a conventional LDPC decoder employing the belief propagation BP decoding algorithm and using the standard flooding schedule according to the state of the art.

The LDPC decoder according to the state of the art as shown in figure 6 receives via an input (IN) the calculated log-likelihood ratios LLRs from the demodulator and stores them temporarily in a RAM as initialization values.

This RAM is connected to several variable node processors as shown in figure 8. The output of the variable node processors is connected to a further RAM provided for the $Q_{VC}$ messages. The addressing of the $Q_{VC}$-random access memory is done using a ROM which stores the code's graph structure. This ROM also controls a switching unit on the output side of the $Q_{VC}$-RAM. The output of the switching unit is connected to several check node processors as shown in figure 7 which update the check to variable messages $R_{CV}$. The updated $R_{CV}$ messages are stored in a further RAM as shown in figure 6. The addressing of the $R_{cv}$-random access memory is done using a second ROM which stores the code's graph structure. This ROM also controls a switching unit on the output side of the $R_{cv}$-RAM. The output to the switching unit is connected to the variable node processors.

The check node processors perform the update of the check to variable messages $R_{CV}$ as described in connection with step S2 of the flowchart shown in figure 4. The updated check to variable messages $R_{CV}$ are stored temporarily in the $R_{CV}$-RAM as shown in figure 6.

The variable node processors perform the update of the variable to check messages $Q_{VC}$ as described in connection with step S3 of the flow chart shown in figure 4. The updated variable to check messages $Q_{VC}$ are stored temporarily in the $Q_{VC}$-RAM.

The conventional LDPC decoder as shown in figure 6 further comprises a RAM for the output $Q_v$ messages calculated by the variable node processors.

A convergence testing block computes the estimate $\hat{\underline{b}}$ and calculates the syndrome vector S as described in connection with step S4 of the flow chart of figure 4. Further the convergence testing block performs the checks according to steps S5, S6, S7 and indicates whether the decoding was successful, i.e. the decoder converged. In case that the decoding was successful the last calculated estimate is output by the LDPC decoder.

The conventional LDPC decoder employing a flooding update schedule as shown in figure 6 has several disadvantages.

The number of iterations necessary until the decoding process has converged is comparatively high. Accordingly the decoding time of the conventional LDPC decoder with flooding schedule is high. When the number of decoding iterations defined by the threshold value is limited the performance of the LDPC decoder according to the state of the art is degraded.

A further disadvantage of the conventional LDPC decoding method and the corresponding LDPC decoder as shown in figure 6 is that checking whether the decoding has converged requires a separate convergens testing block for performing convergence testing. The convergence testing block of a conventional LDPC decoder as shown in figure 6 calculates a syndrome vector S by multiplying the parity check matrix H with the estimate vector $\hat{\underline{b}}$

Another disadvantage of the conventional LDPC decoding method employing a flooding schedule and the corresponding LDPC decoder as shown in figure 6 resides in that the necessary memory size is high. The LDPC decoder as shown in figure 6 comprises four random access memories (RAM), i.e. the RAM for the input $P_V$ messages, a RAM for the output $Q_V$ messages, a further RAM for the $Q_{VC}$ messages and finally a RAM for the $R_{CV}$ messages. Furthermore the LDPC decoder includes two read only memories (ROM) for storing the structure of the Tanner graph.

Accordingly it is the object of the present invention to provide LDPC decoder overcoming the above mentioned disadvantages, in particular providing a LDPC decoder which needs a small number of iterations for decoding a received codeword.

Furthermore, another objective of the present invention is to describe a low complexity generic encoder/ decoder architecture that enables encoding/decoding of various rate and length LDPC codes on the same hardware.

This object is achieved by a LDPC decoder having the features of claim 1 and claim 12.

The invention provides a LDPC decoder for decoding a noisy codeword (Y) received from a noisy channel, as a result of transmitting through the noisy channel a codeword (b) having a number (N) of codeword bits which belongs to a length (N) low-density parity-check code for which a (MxN) parity check matrix (H) is provided and which satisfies $H*b^T=0$, wherein codeword (Y) has a number (N) of codeword bits which consists of K information bits and M parity check bits,

wherein the parity check matrix H represents a bipartite graph comprising N variable nodes (V) connected to M check nodes (C) via edges according to matrix elements $h_{ij}$ of the parity check matrix H,

wherein the LDPC decoder performs the following decoding steps:

(a) receiving the noisy LDPC codeword (Y) via said communication channel ;

(b) calculating for each codeword bit (V) of said transmitted LDPC codeword (b) and a priori estimate ($Q_v$) that the codeword bit (V) has a predetermined value from the received noisy codeword (Y) and from predetermined parameters of said communication channel ;

(c) storing the calculated a priori estimates ($Q_v$) for each variable node (V) of said bipartite graph, corresponding to a codeword bit (V), in a memory as initialization variable node values;

(d) storing check-to-variable messages ($R_{CV}$) from each check nodes (C) to all neighboring variable nodes (V) of said bipartite graph in said memory, initialized to zero ;

(e) calculating iteratively messages on all edges of said bipartite graph according to a serial schedule, in which at each iteration, all check nodes of said bipartite graph are serially traversed and for each check node (C) of said bipartite graph the following calculations are performed :

(e1) reading from the memory stored messages ($Q_v$) and stored check-to-variable messages ($R_{CV}$) for all neighboring variable nodes (V) connected to said check node (C) ;

(e2) calculating by means of a message passing computation rule, for all neighboring variable nodes (V) connected to said check node (C) variable-to-check messages ($Q_{VC}$) as a function of the messages ($Q_v$) and the check-to-variable messages ($R_{CV}$) read from said memory.;

(e3) calculating by means of a message passing computation rule, for all neighboring variable nodes (V) connected to said check node (C) updated check-to-variable messages ($R_{CV}^{new}$) as a function of the calculated variable-to-check message ($Q_{VC}$) ;

(e4) calculating by means of a message passing computation rule, for all neighboring variable nodes (V) connected to said check node (C) updated a-posteriori messages ($Q_v^{new}$) as a function of the former ($Q_V$) messages and the updated check-to-variable messages ($R_{CV}^{new}$) ;

(e5) storing the updated a posteriori messages ($Q_V^{new}$) and updated check-to-variable messages ($R_{CV}^{new}$) back into said memory;

(f) calculating the decoded codeword (b*) as a function of the a-posteriori messages (Q) stored said memory ;

(g) checking whether the decoding has converged by checking if the product of the parity check matrix and the decoded codeword is zero ;

(h) Outputting the decoded codeword (b*) once the decoding has converge or once a predetermined maximum number of iterations has been reached.

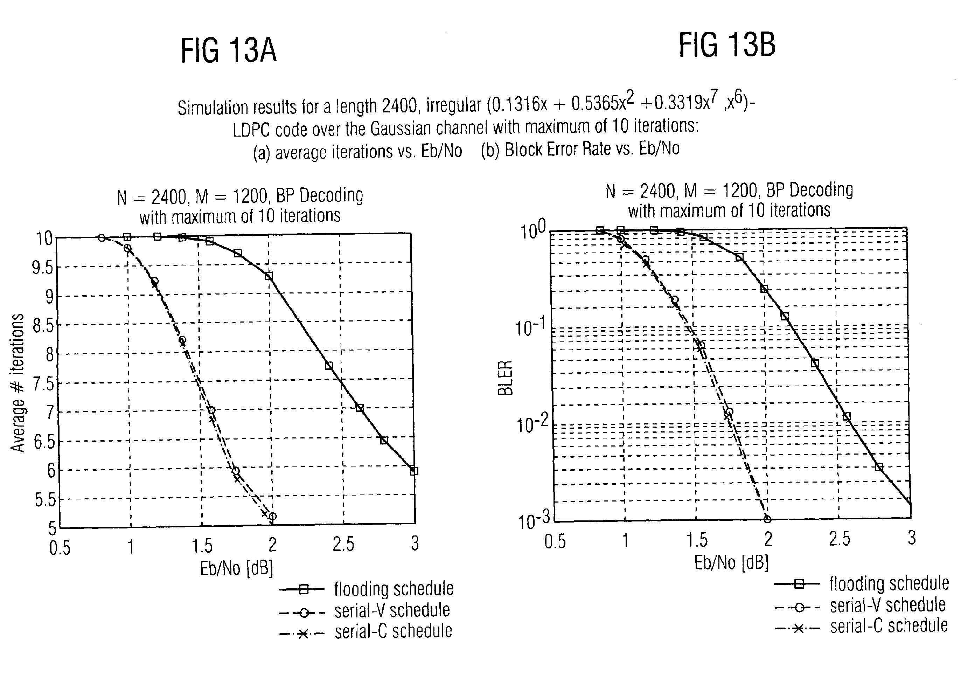

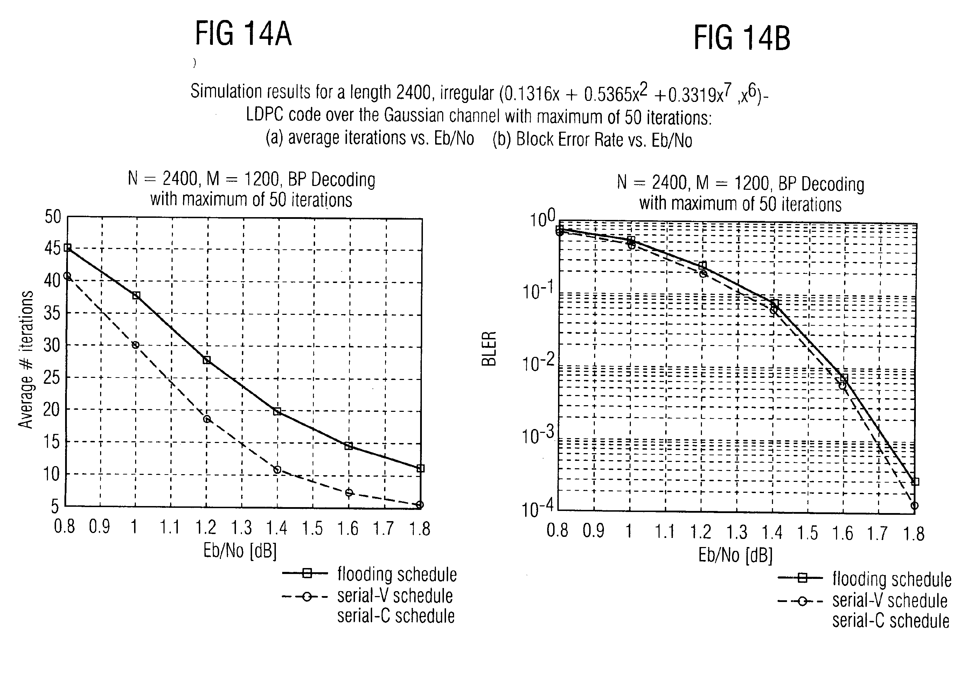

The main advantage of the LDPC decoder according to the present invention is that the LDPC decoder converges in approximately half the number of iterations (as shown in Figures 13A and 14A). As a result the performance of a LDPC decoder employing a serial schedule is better than the performance of a LDPC decoder employing a flooding schedule when the number of decoder iterations is limited as in any practical application (as shown in Figures 13B and 14B). Alternatively, for a given performance and decoder throughput, approximately half the processing hardware is needed for a LDPC decoder employing a serial schedule compared to a LDPC decoder employing a flooding schedule.

A further advantage of the LDPC decoder according to the present invention is that the memory size of the LDPC decoder according to the present invention is approximately half the size compared to the necessary memory size of the corresponding LDPC decoder according to the state of the art as shown in figure 6.

The decoding method employed by the LDPC decoder according to the present invention can be applied to generalized LDPC codes, for which the left and right side nodes in the bipartite graph represent constraints by any arbitrary code.

In a preferred embodiment of the decoder according to the present invention, the codes for which the decoding is applied are LDPC codes in which the left side nodes represent constraints according to repetition codes and the right side nodes represent constraints according to parity-check codes. In a preferred embodiment of the LDPC decoder according to the present invention the employed message passing computation rule procedure is a belief propagation (BP) computation rule which is also known as the Sum-Product procedure.

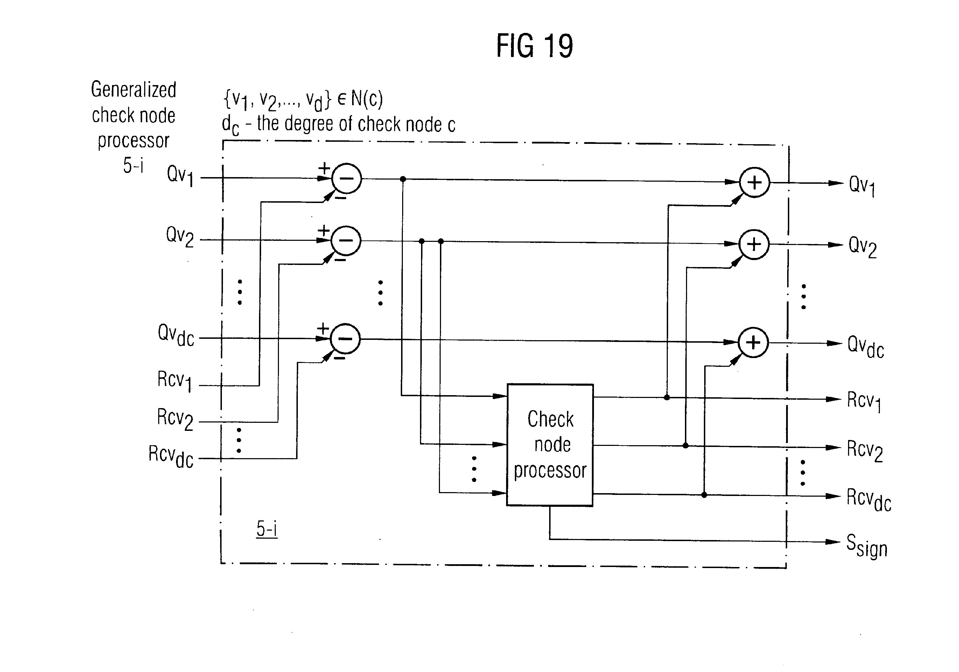

This preferred embodiment of the generalized check node processor is shown in Figure 19.

In an alternative embodiment the employed message passing computation rule is a Min-Sum procedure.

In a preferred embodiment of the LDPC decoder for decoding a low density parity check codeword according to the present invention the calculated a-priory estimates are log-likelihood ratios (LLR).

In an alternative embodiment the calculated a-priori estimates are probabilities.

In a preferred embodiment of the LDPC decoder for decoding a low density parity check codeword a decoding failure is indicated when the number of iterations reaches an adjustable threshold value.

In the following preferred embodiments of the LDPC decoder for decoding a low density parity check codeword are described with reference to the enclosed figures.

Figure 1 shows an example of a sparse parity check matrix H and a corresponding bipartite Tanner graph according to the state of the art ;

Figure 2 shows a simple example of a bipartite Tanner graph according to the state of the art.

Figure 3 shows transceivers connected via a data communication channel including a LDPC encoder and a LDPC decoder for decoding the LDPC code defined by the bipartite Tanner graph as shown in figure 2.

Figure 4 shows a flow chart of a belief propagation (BP)-LDPC decoder employing a flooding schedule according to the state of the art ;

Figure 5 shows several iteration steps for a belief propagation LDPC decoder using the standard flooding schedule according to the state of the art ;

Figure 6 shows a block diagram of a conventional LDPC decoder according to the state of the art,

Figure 7 shows a circuit diagram of a check node processor within a conventional LDPC decoder as shown in figure 6;

Figure 8 shows a circuit diagram for a variable node processor as provided within an LDPC decoder according to the state of the art as shown in figure 6;

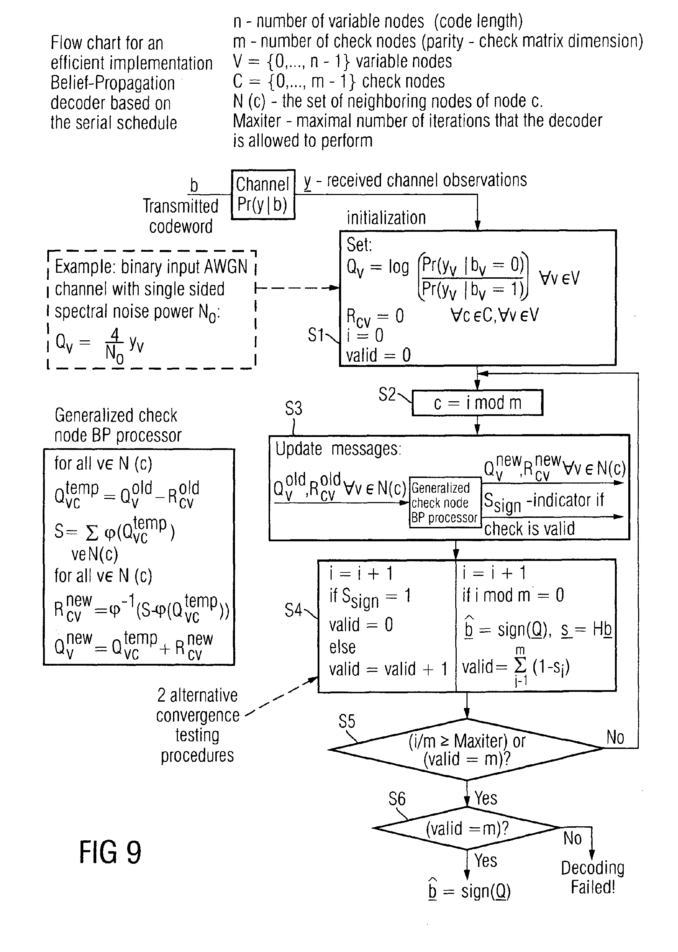

Figure 9 shows a flowchart of a belief propagation (BP)-LDPC decoder using a serial schedule according to the present invention;

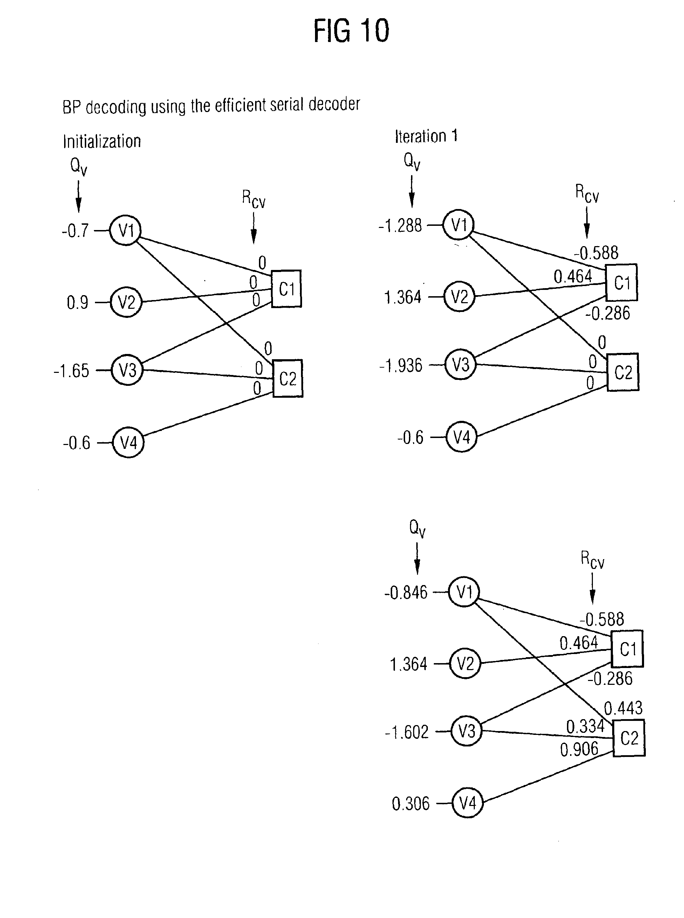

Figure 10 shows several iteration steps of the LDPC decoding method according to the present invention for the simple example of figures 2, 3;

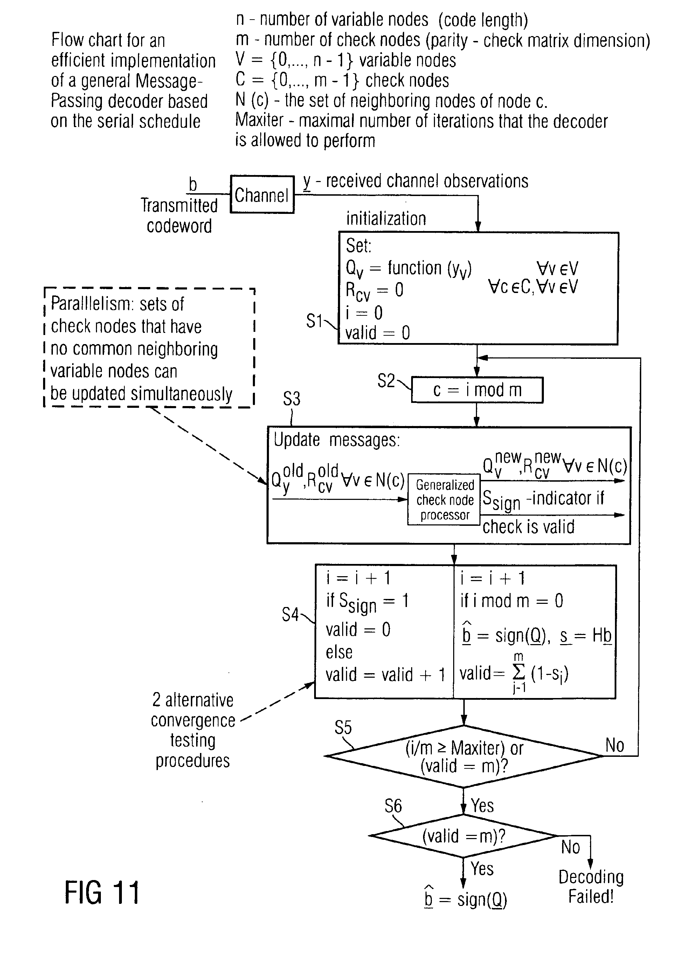

Figure 11 shows a flowchart of a general message passing LDPC decoder using an serial schedule according to the present invention.

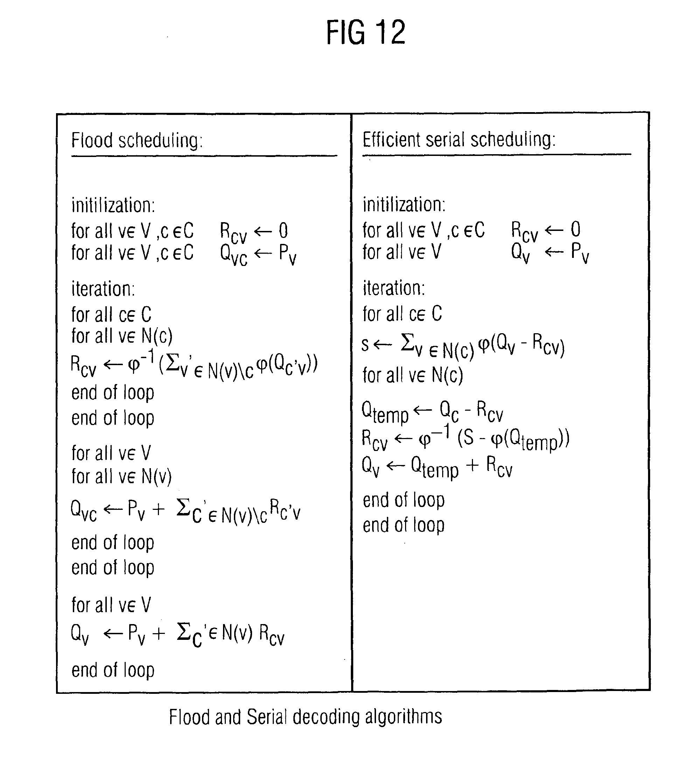

Figure 12 shows a table for comparing an LDPC decoding procedure using a conventional flooding schedule and an LDPC decoding method using an efficient serial schedule according to the present invention;

Figure 13A shows a simulation result of the average number of iterations necessary for a conventional LDPC decoder employing a flooding schedule and an LDPC decoder according to the present invention employing a serial schedule, when the decoders are limited to 10 iterations;

Figure 13B shows a simulation result of the block error rate for a LDPC decoder according to the state of the art employing a flooding schedule and of an LDPC decoder according to the present invention employing a serial schedule, when the decoders are limited to 10 iterations ;

Figure 14A shows a simulation result of the average number of iterations for a conventional flooding schedule LDPC decoder and an LDPC decoder according to the present invention employing a serial schedule, when the decoders are limited to 50 iterations ;

Figure 14B shows the block error rate of a conventional flooding schedule LDPC decoder in comparison to an LDPC decoder according to the present invention employing a serial schedule, when the decoders are limited to 50 iterations ;

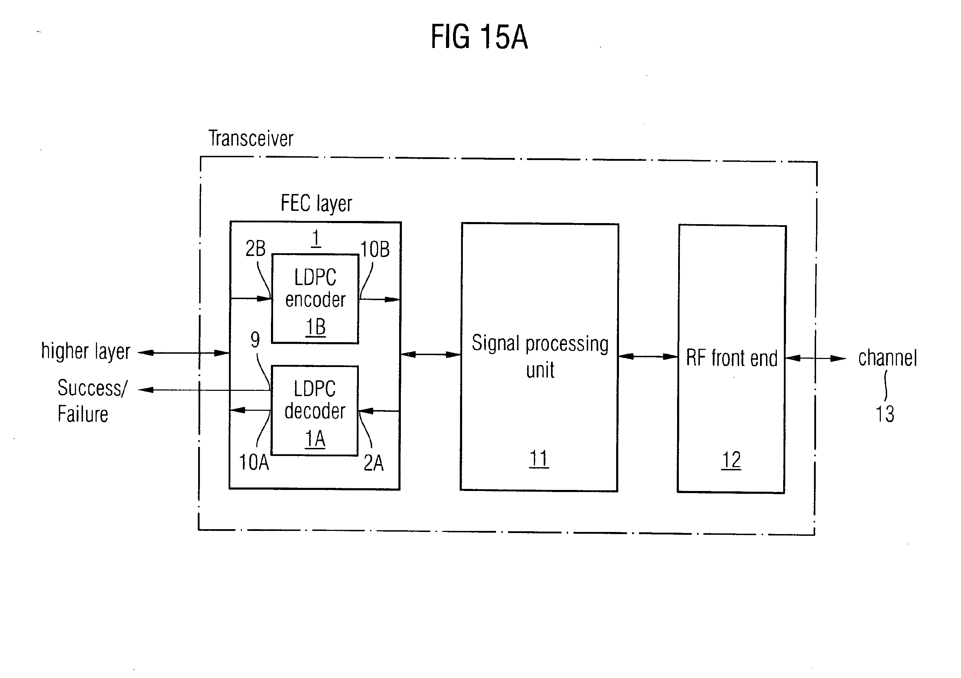

Figure 15a shows a transceiver comprising an LDPC encoder/decoder according to the present invention.

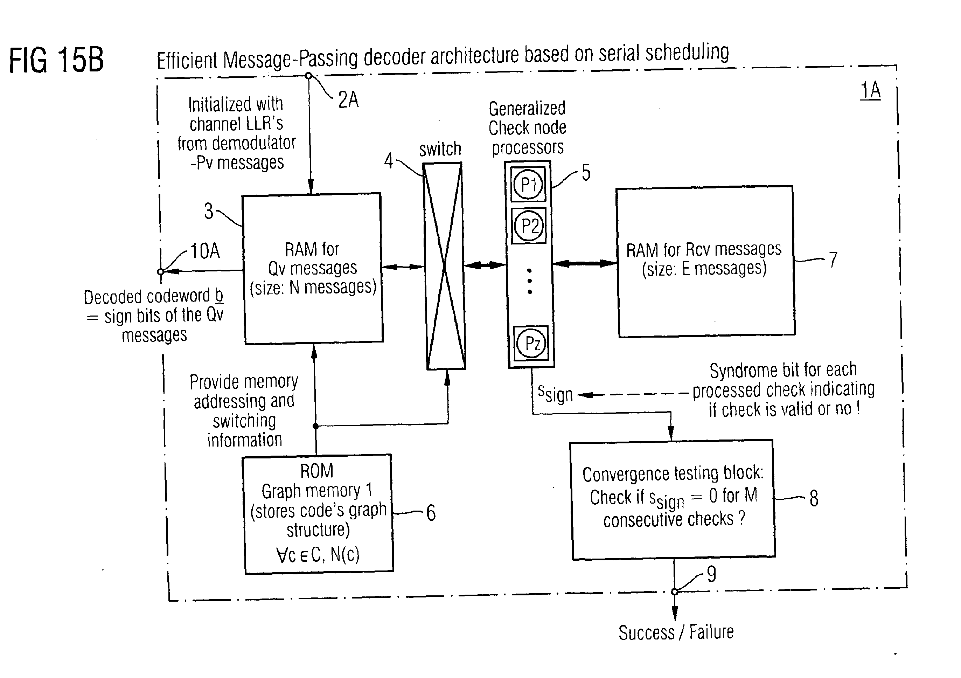

Figure 15b shows an efficient message passing decoder architecture according to the present invention ;

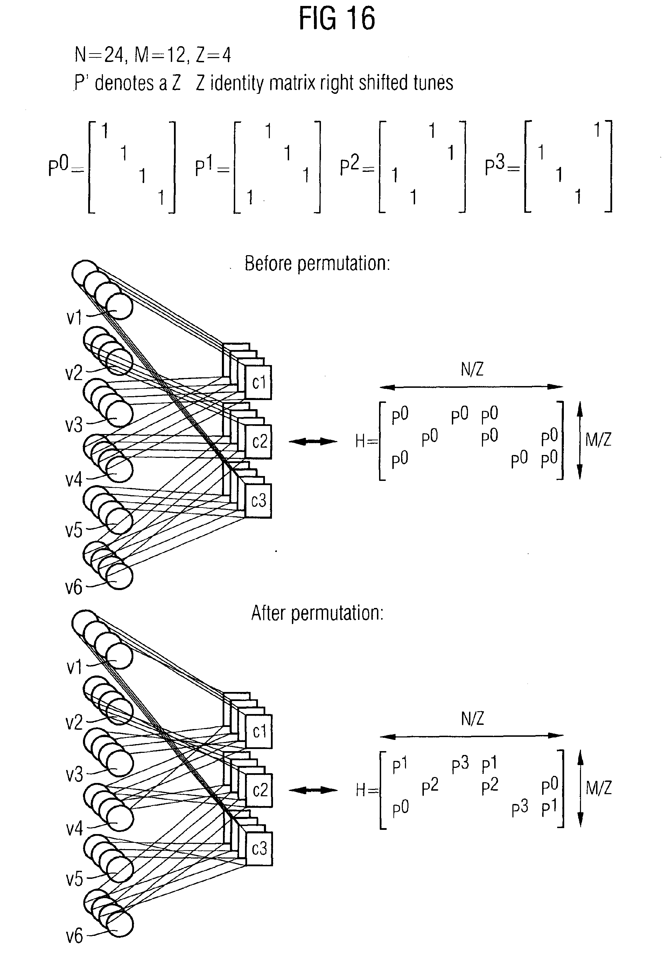

Figure 16 shows an example for the construction of a preferred LDPC code adapted to the decoder architecture according to the present invention as shown in figure 15b ;

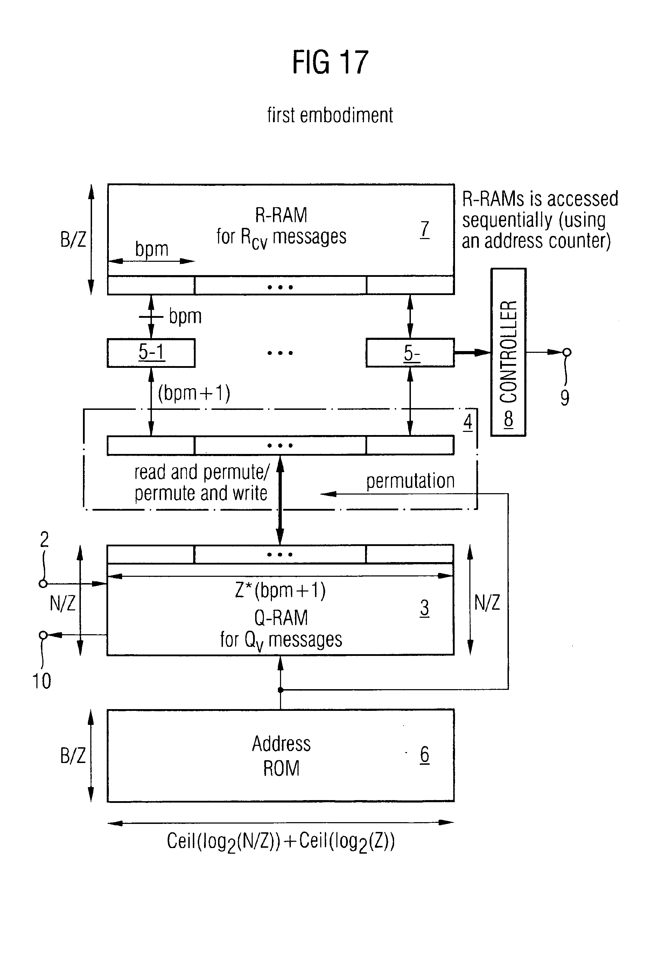

Figure 17 shows a LDPC decoder architecture according to a first embodiment of the present invention;

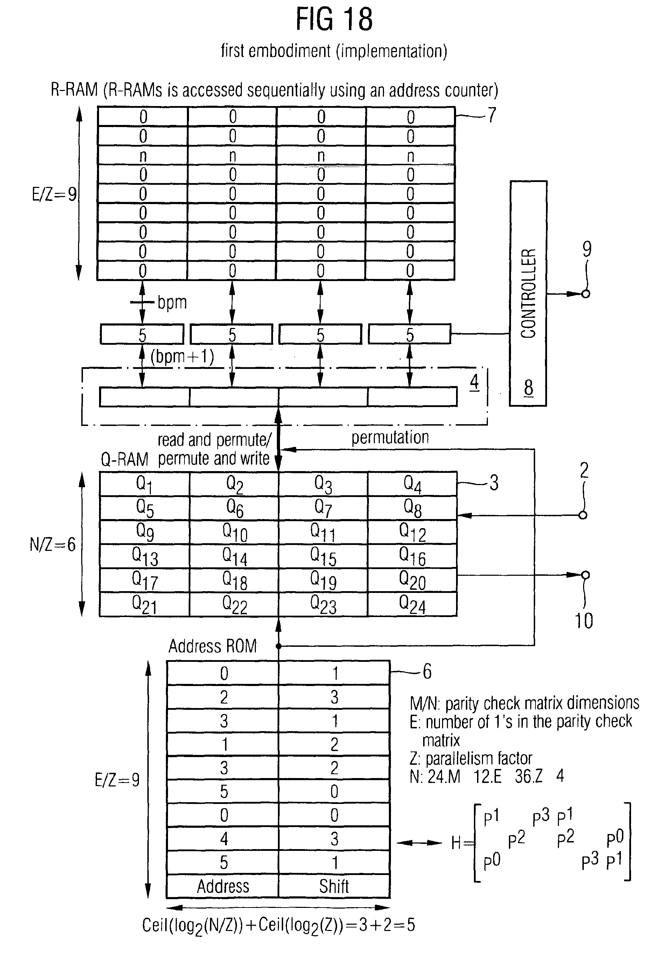

Figure 18 shows a specific example for an implementation of a LDPC decoder according to a first embodiment of the present invention using the LDPC code of the example shown in figure 16;

Figure 19 shows a generalized check node processor as used by the LDPC decoder according to the present invention ;

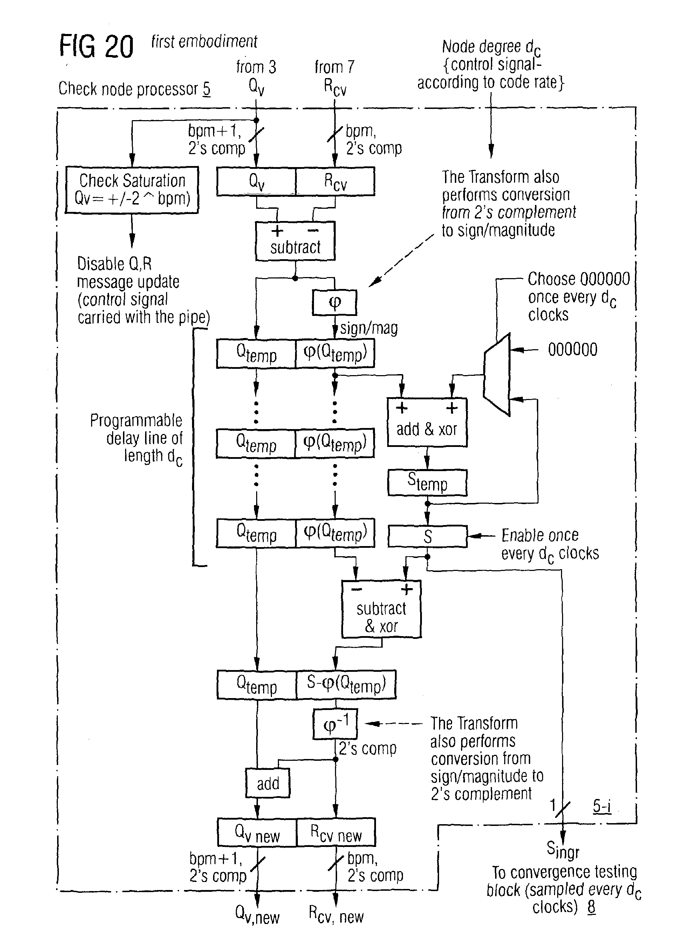

Figure 20 shows a preferred implementation of a generalized check node processor as provided within the LDPC decoder according to the first embodiment of the present invention ;

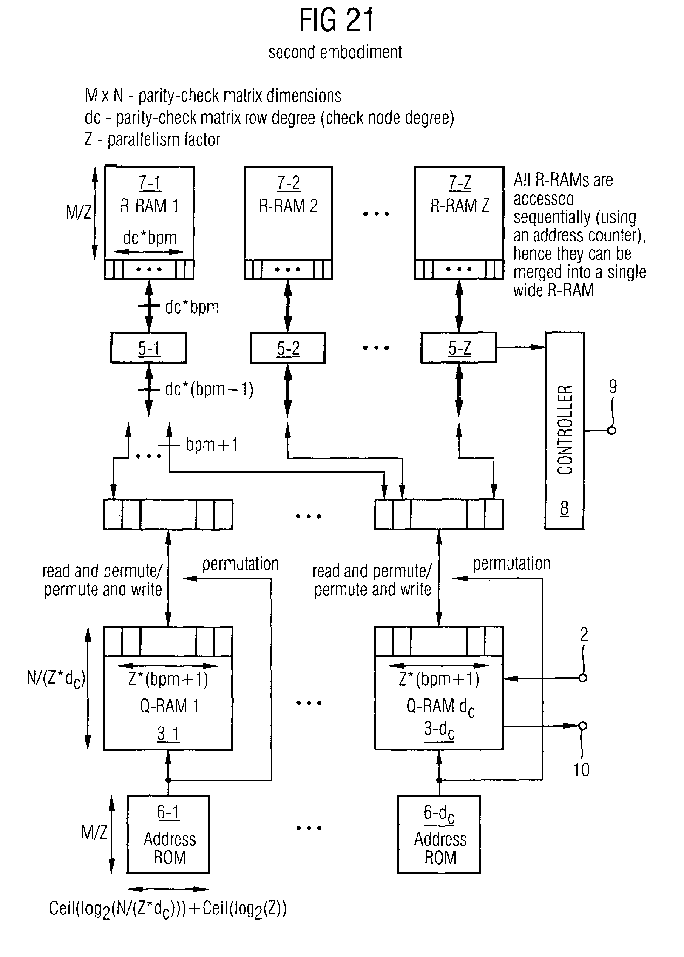

Figure 21 shows a block diagram of a LDPC decoder according to a second embodiment of the present invention ;

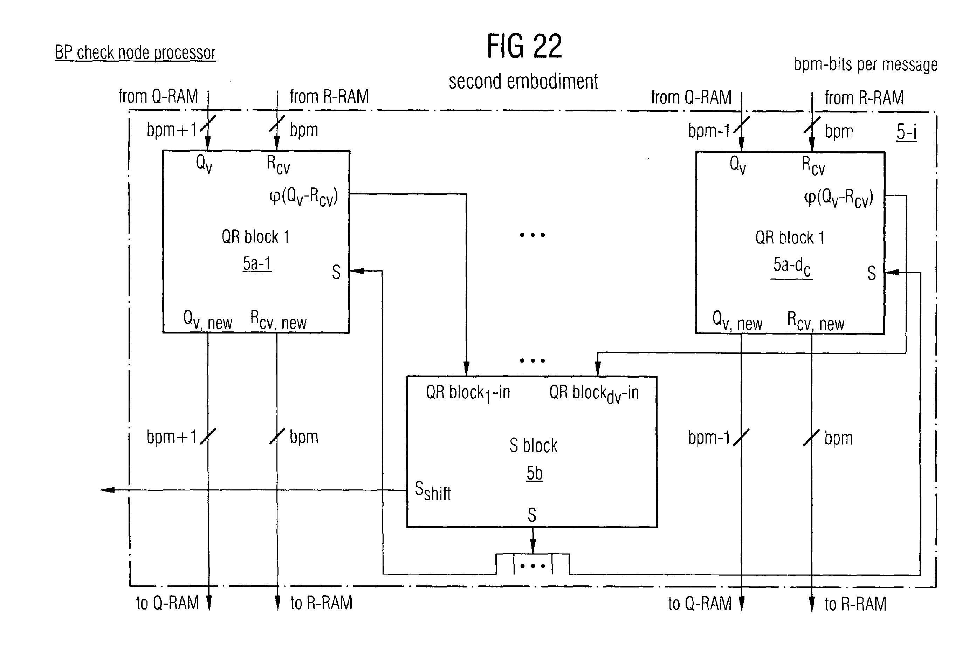

Figure 22 shows a block diagram of an generalized check node processor as used in the LDPC decoder in the second embodiment of the present invention as shown in figure 21 ;

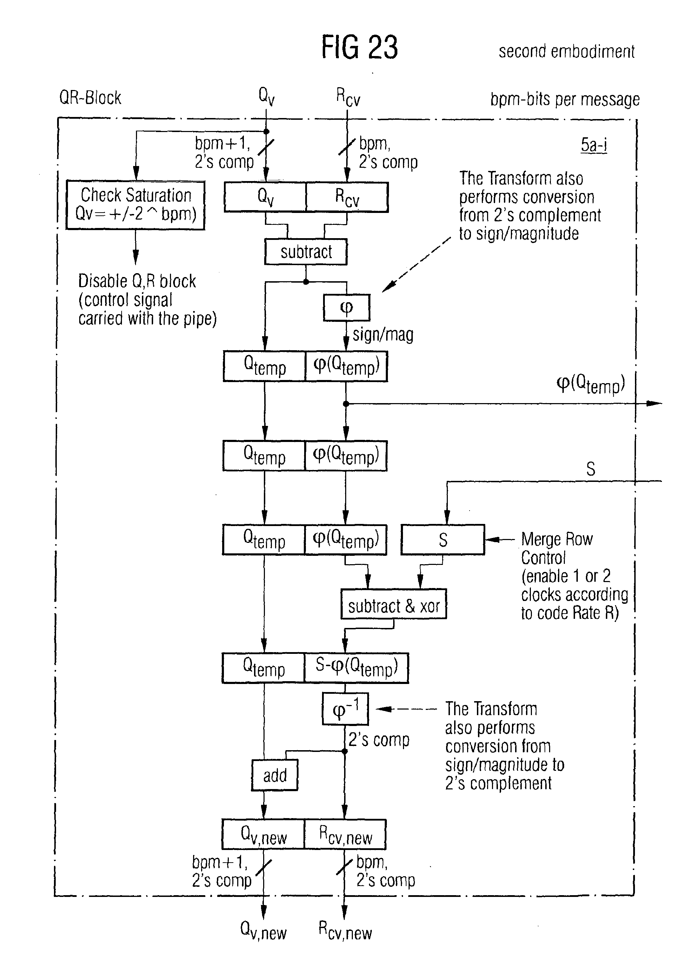

Figure 23 shows an implementation of the QR-block in the generalized check node processor of the LDPC decoder according to the second embodiment as shown in figure 22 ;

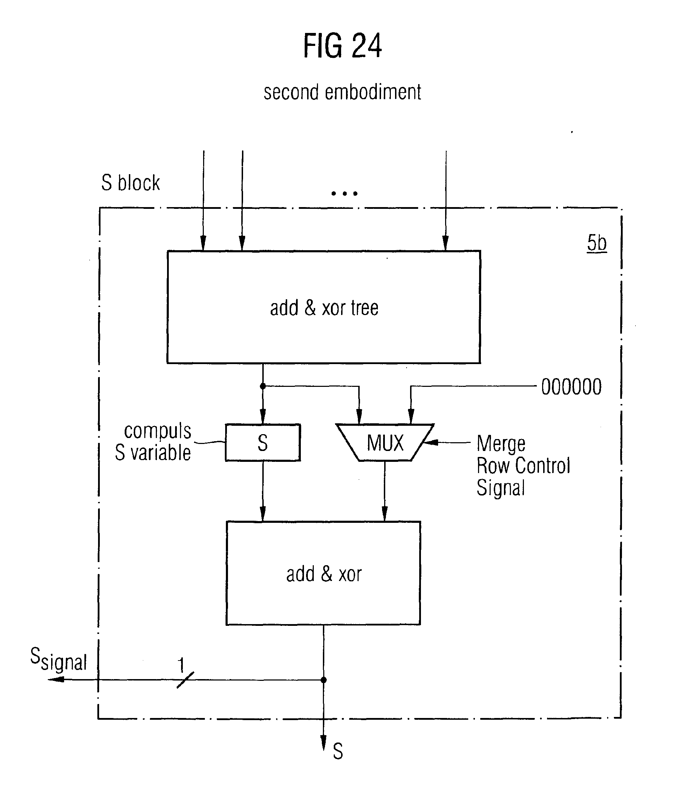

Figure 24 shows an implementation of the S-block within the generalized check node processor of the LDPC decoder according to the second embodiment of the present invention as shown in figure 22 ;

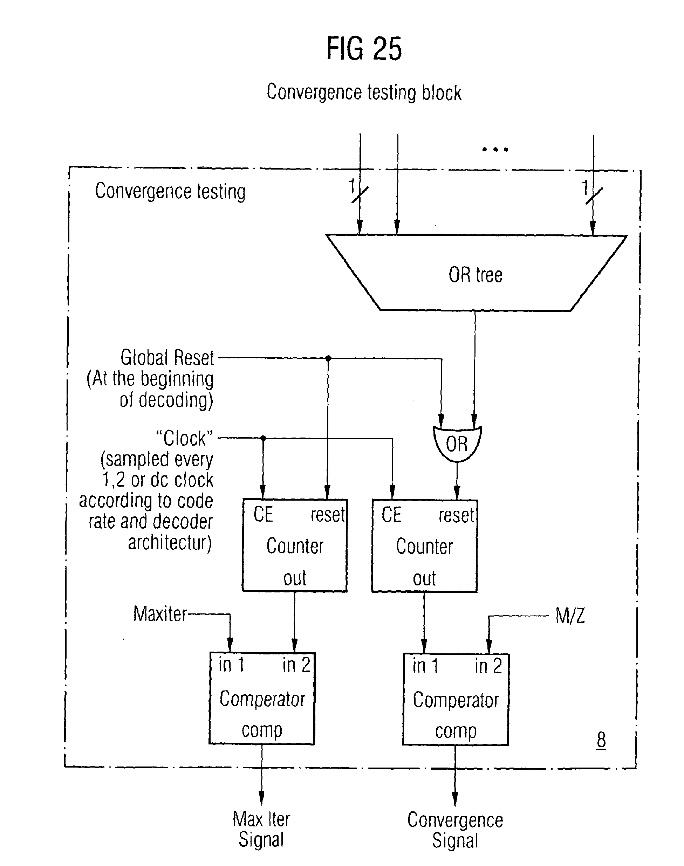

Figure 25 shows a preferred embodiment of the convergence testing block within the LDPC decoder according to the present invention as shown in figure 15 ;

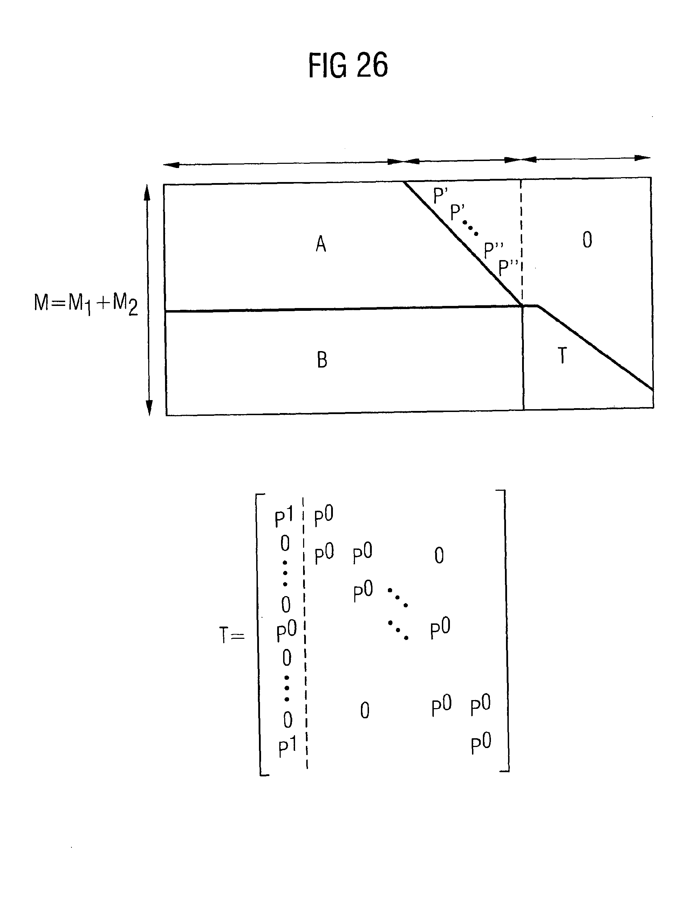

Figure 26 shows an example for a parity check matrix structure in a LDPC encoder according to the present invention ;

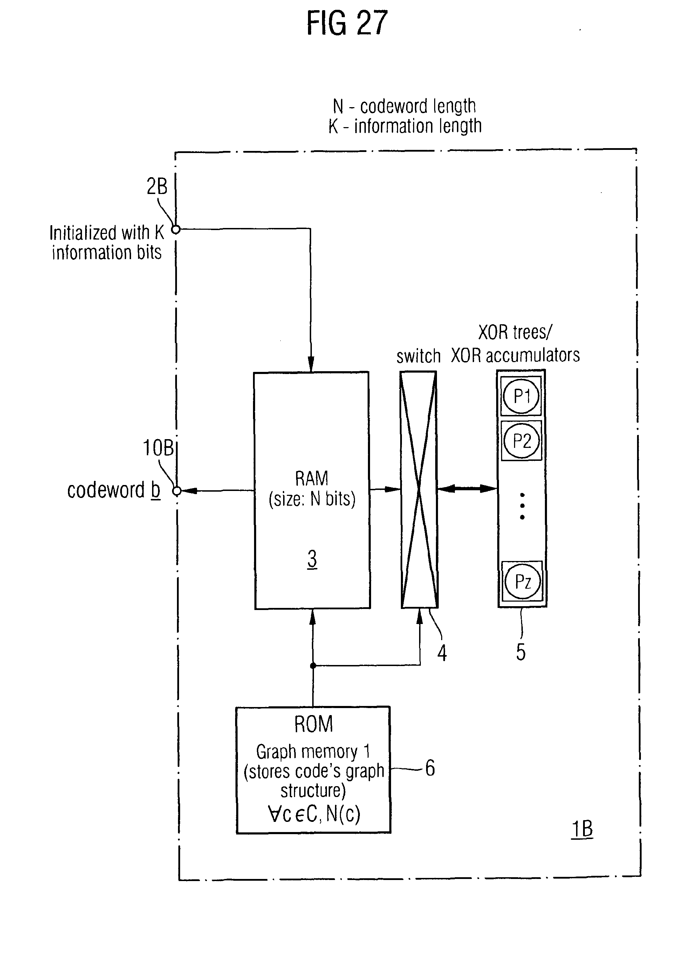

Figure 27 shows a preferred embodiment of a message passing encoder according to the present invention.

As can be seen from figure 9 the method for decoding a low density parity check codeword according to the present invention is performed on the basis of the received channel observation, i.e. the estimate values or estimates which indicate that a received codeword bit has a predetermined value. The estimates are calculated from the received codeword Y and predetermined parameters of the communication channel. The predetermined parameters of the communication channel are known. In an alternative embodiment of the present invention, if the parameters of the communication channel are unknown, a Min-Sum message-passing computation rule can be used, for which the parameters of the communication channel are not needed.

A general message passing decoding procedure covering all embodiments is shown in figure 11. In a preferred embodiment the estimates are the log-likelihood ratios of the received bits (LLR).

Figure 15b shows a block diagram of a preferred embodiment of the LDPC decoder 1A according to the present invention. The LDPC decoder 1A has an input 2a and receives the a-priori estimate values based on the channel observations from the demodulator. The a-priori estimates are in a first embodiment calculated a-priori log-likelihood ratios (LLR). In an alternative embodiment the calculated estimates are a-priori probabilities.

In an initialization step S1 as shown in figure 9 the calculated log-likelihood ratios or probabilities are stored temporarily as initialization values in a random access memory (RAM) 3 within the LDPC decoder 1A. The memory 3 is connected via a switching unit 4 to a block including several generalized check node processors. The generalized check node processors 5 are also connected to a random access memory 7. The memory 3 and the switching unit 4 are controlled by a read only memory 6 storing the bipartite Tanner graph of the used LDPC code. The generalized check node processors 5 are provided for updating the messages between the nodes of the Tanner graph. The generalized check node processors are provided with $R_{CV}$ messages from memory 7 and with $Q_V$ messages from memory 3 via the switching unit 4. The generalized check node processors 5 compute new updated values for the $R_{CV}$ and $Q_V$ messages. The updated $R_{CV}$ messages are stored back in memory 7 and the updated $Q_V$ messages are stored back in memory 3 via the switching unit 4.

In a preferred embodiment of the present invention the generalized check node processors 5 output for each check node of the bipartite Tanner graph a sign bit $S_{sign}$ which is checked by a convergence testing block 8 which checks whether the LDPC decoder 1 has converged. In an alternative embodiment of the present invention a standard convergence testing block can be used as shown in Figure 9 step S4 (right alternative). When the converging testing block 8 realizes that the LDPC decoding process has converged it indicates this by outputting a success indication signal via output 9 of the LDPC decoder 1. In case that no convergence could be achieved the LDPC decoder 1 indicates such a failure via output 9. In case of success the LDPC decoder 1 outputs the decoded codeword calculated in the last iteration step via a data output 10a.

The generalized check node processor 5 of figure 15b is shown in more detail in figure 19, wherein each generalized check node processor 5 includes a conventional check node processor shown in figure 7 and further subtracting and summing means.

In the initialization step S1 shown in figure 9 the check to variable messages $R_{CV}$ are initialized with the value zero for all check nodes and for all variable nodes. Further an iteration counter i is set to zero. A further counter (valid) is also initialized to be zero.

In a step S2 a check node number c is calculated depending on the iteration counter i and the number of check nodes M within the Tanner graph :

$$(7)$$

$$c = i \cdot \bmod m$$

In step S3 the generalized check node processors 5 perform the updating of the messages corresponding to check node c.

In a preferred embodiment of the present invention the generalized check node processor implements a BP computation rule according to the following equations:

$$(8)$$

$$R_{CV}^{new} = \varphi^{-1}\left(S - \varphi\left(Q_{vc}^{temp}\right)\right)$$
$$Q_V^{new} = Q_{vc}^{temp} + R_{CV}^{new}$$

for all v∈N(C), wherein N(C) is the set of neighboring nodes of check node c
and wherein

$$Q_{VC}^{temp} = Q_V^{old} - R_{CV}^{old}$$

$$S = \sum_{v \in N(c)} \varphi\left(Q_{vc}^{temp}\right)$$

with

$$\varphi(x) = \left(sign(x), -\log \tanh\left(\frac{|x|}{2}\right)\right) \qquad (9)$$

$$\varphi^{-1}(x) = (-1)^{sign}\left(-\log\left(\tanh\left(\frac{x}{2}\right)\right)\right)$$

and with

$$sign(x) = \begin{cases} 0 & x \geq \varnothing \\ 1 & x < \varnothing \end{cases}$$

In an alternative embodiment of the present invention the generalized check node processor implements a Min-Sum computation rule according to the following equations:

$$\text{for all} \quad v \in N(c)$$
$$Q_{vc}^{temp} = Q_v^{old} - R_{cv}^{old}$$
$$\text{for all} \quad v \in N(c) \qquad (10)$$
$$R_{cv}^{new} = \prod_{v' \in N(c)/v} (-1)^{sign(Q_{v'c}^{temp})} \min_{v' \in N(c)/v} \{Q_{v'c}^{temp}\}$$
$$Q_v^{new} = Q_{vc}^{temp} + R_{cv}^{new}$$

For each check node c of the bipartite Tanner graph and for all neighboring nodes connected to said check node c the input messages $Q_{VC}$ to the check node from the neighboring variable nodes v and the output messages $R_{CV}$ from said check node c to said neighboring variable nodes v are calculated by means of a message-passing computation rule. Instead of calculating all messages $Q_{VC}$ from variable nodes V to check nodes c and then all messages $R_{CV}$ from check node c to variable nodes v as done in the flooding schedule LDPC decoder according to the state of the art. The decoding method according to the present invention calculates serially for each check node c all messages $Q_{VC}$ coming into the check node C and then all messages $R_{CV}$ going out from the check node c.
This serial schedule according to the present invention enables immediate propagation of the messages in contrast to the flooding schedule where a message can propagate only in the next iteration step.
The messages $Q_{VC}$ are not stored in a memory. Instead, they are computed on the fly from the stored $R_{CV}$ and $Q_V$ messages according to $Q_{VC} = Q_V - R_{CV}$.
All check nodes c which have no common neighboring variable nodes can be updated in the method according to the present invention simultaneously.
After the messages have been updated by the check node processors 5 in step S3 the iteration counter i is incremented in step S4.
In one preferred embodiment of the present invention, in step S3 an indicator

$$S_{sign} = Sign( \sum_{v \in N(c)} \varphi(Q_{vc}^{temp}) \, .$$

is calculated by the check node processors 5 indicating whether the check is valid. In step S4 if $S_{sign}$=1 (check is not valid) the valid counter is reset (valid = 0). In contrast when the check is valid ($S_{sign}$=0) the valid counter is incremented in step S4.

In another embodiment of the present invention a standard convergence testing mechanism is used as shown in figure 16, in which in step S4 a syndrome $s=H\underline{b}$ is computed where

$$\underline{b} = sign(\underline{\hat{Q}}).$$

In step S5 it is checked whether the number of iterations (i/m) is higher than a predefined maximum iteration value, i. e. threshold value or whether the valid counter has reached the number of check nodes m. If the result of the check in step S5 is negative the process returns to step S2. If the result of the check in step S5 is positive it is checked in step S6 whether the valid counter is equal to the number M of check nodes. If this is not true, i.e. the iteration was stopped because a maximum iteration value MaxIter has been reached the LDPC decoder 1 outputs a failure indicating signal via output 9. In contrast when the valid counter has reached the number of check nodes M the decoding was successful and the LDPC decoder 1 outputs the last estimate $\underline{b}$ as the decoded value of the received codeword.

$$\underline{b} = Sign(\hat{Q})$$

Figure 10 shows a belief propagation decoding procedure performed by the LDPC decoder 1 according to the present invention using the algorithm shown in figure 9 for the simple examples of figures 2, 3.

The calculated log-likelihood ratios LLRs output by the demodulator P=[-0.7 0.9 -1.65 -0.6] are stored as decoder inputs in the memory 3 of the LDPC decoder 1. The memory 7 which stores the check to variable messages $R_{CV}$ is initialized to be zero in the initialization step S1.

In the given example of figure 10 the LDPC decoder 1 performs one additional iteration step (iteration 1) before convergence of the decoder 1 is reached. For each check node c1, c2 the variable to check messages $Q_{VC}$ are computed or calculated for each variable node V which constitutes a neighboring node of said check node c. Then for each variable node which is a neighboring node of said check node c the check to variable messages $R_{CV}$ and the a-posteriori messages $Q_v$ are updated using the above mentioned equations in step S3 of the decoding method and stored in memory 7 and memory 3 respectively.

The convergence testing block 8 counts the valid checks according to the sign values $S_{sign}$ received from the generalized check node processor. A check is valid if $S_{sign}$ = 0. Once M consecutive valid checks have been counted (M consecutive Ssign variables are equal to 0), it is decided that the decoding process has converged and the actual estimate value $\underline{b}$=Sign($\hat{Q}$) is output by terminal 10 of the LDPC decoder 1.

Alternatively, the standard convergence testing block used by the state of the art flooding decoder can be used for the serial decoder as well. The standard convergence testing block computes at the end of each iteration a syndrome vector s = Hb$^T$, where b = sign(Q). If the syndrome vector is equal to the 0 vector then the decoder converged. In the given example, the serial decoder converges after one iteration.

By comparing figure 10 with figure 5 it becomes evident, that the decoding method according to the present invention (figure 10) needs only one iteration step whereas the conventional LDPC decoding method (figure 5) which uses the flooding schedule needs two iteration steps before the decoder has converged.

Accordingly one of the major advantages of the LDPC decoding method according to the present invention is that average number of iterations needed by the LDPC decoder 1 according to the present invention is approximately half the number of iterations that are needed by a conventional LDPC decoder using a flooding schedule.

Figure 13A, figure 14A show a simulation result for a block length N=2400 and an irregular LDPC code over a Gaussian channel for ten and for fifty iterations. As becomes evident from figures 13A, 14A the necessary number of iterations for an LDPC decoder 1 according to the present invention using a serial schedule is significantly lower than the number of iterations needed by a conventional LDPC decoder using a flooding schedule.

Further the performance of the LDPC decoder 1 according to the present invention is superior to the performance of a conventional LDPC decoder using a flooding schedule. Figures 13B, 14B show a simulation result of the block error rate BLER of the LDPC decoder 1 in comparison to a conventional LDPC decoder for ten and fifty iterations. As can be seen from figure 13B, 14B the block error rate BLER performance of the LDPC decoder 1 according to the present invention is significantly better than the block error rate BLER performance of the conventional LDPC decoder using a flooding schedule when the number of iterations that the decoder is allowed to perform is limited.

A further advantage of the LDPC decoder 1 according to the present invention as shown in figure 15b is that the memory size of the memories 3, 7 within the LDPC decoder 1 according to the present invention is significantly lower (half the memory size) than the memory size of the random access memories (RAM) provided within the state of the art LDPC decoder shown in figure 6. Since in the LDPC decoder 1 a serial schedule is employed it is not necessary to provide a memory for the $Q_{VC}$ messages. Since the same memory which is initialized with messages $P_V$ is used also for storing the messages $Q_V$ the LDPC decoder 1 having an architecture which is based on the serial schedule requires only a memory for E+N messages (while the state of the art LDPC decoder shown in figure 6 requires memory for 2E+2N messages), where E is the number of edges in the code's Tanner graph (usually, for good LDPC codes 3N<E<4N)

A further advantage of the LDPC decoder 1 employing the decoding method according to the present invention is that only one data structure containing N(C) for all check nodes c∈C is necessary. In the standard implementation of a conventional LDPC decoder using the flooding schedule two different data structures have to be provided requiring twice as much memory for storing the bipartite Tanner graph of the code. If an LDPC decoder using the conventional flooding schedule is implemented using only a single data structure an iteration has to be divided into two non overlapping calculation phases. However, this results in hardware inefficiency and increased hardware size.

It is known that LDPC codes which approach the channel capacity can be designed with concentrated right degrees, i.e. the check nodes c have constant or almost constant degrees. In such a case only the variable node degrees are different. While the conventional flooding LDPC decoder for such irregular codes needs a more complex circuitry because computation units for handling a varying number of inputs are needed. A LDPC decoder implemented according to the present invention remains with the same circuit complexity even for such irregular codes. The reason for that is that the LDPC decoder 1A employing the serial schedule requires only a check node computation unit which handles a constant number of inputs.

A further advantage of the LDPC decoder 1A in comparison to a conventional LDPC decoder is that a simpler convergence testing mechanism can be used. Whereas the LDPC decoder according to the state of the art has to calculate a syndrome vector S, the indicator $S_{sign}$ of the LDPC decoder 1 is a byproduct of the decoding process. In the convergence testing block 8 of the LDPC decoder 1 according to the present invention it is only checked whether the sign of the variable $S_{sign}$ is positive for M consecutive check nodes. And there is no need to perform a multiplication of the decoded word with the parity check matrix H at the end of each iteration step in order to check whether convergence has been reached.

Iterations of a LDPC decoder employing a flooding schedule can be fully parallised, i.e. all variable and check node messages are updated simultaneously. The decoding method according to the present invention is serial, however, the messages from sets of nodes can be updated in parallel. When the check nodes are divided into subsets such that no two check nodes in a subset are connected to the same variable node V then the check nodes in each subset can be updated simultaneously.

Figure 12 includes a table which shows the flooding schedule used by the conventional LDPC decoder in comparison to the efficient serial scheduling scheme as employed by the LDPCdecoding method according to the present invention.

Figure 15a shows a transceiver comprising an LDPC encoder/decoder according to the present invention. The transceiver includes a forward error correction layer (FEC-layer) which is implemented by the LDPC encoder/decoder 1 as shown in figure 15a. The LDPC decoder 1A according to the present invention is shown in more detail in figure 15b whereas the preferred embodiment of the LDPC encoder 1B is shown in figure 27. The LDPC encoder/decoder 1 according to the present invention allows to perform encoding and decoding various rate and length codes on the same hardware. In a preferred embodiment the LDPC encoder/decoder 1 supports multi rate and length LDPC-codes. In a preferred embodiment the LDPC encoder/decoder 1 according to the present invention is switchable between different LDPC codes stored in a memory of said device. The LDPC encoder/decoder device 1 is connected via a signal processing unit 11 and a transceiver front end 12 to a communication channel 13. The signal processing unit 11 and a transceiver front end 12 adopt the encoded codeword at the output of LDPC encoder 1B for transmission over the given communication channel 13. Furthermore, the transceiver front end 12 and the signal processing unit 11 process the received signal from the given communication channel 13 and provide the LDPC decoder 1A with a-priori estimates of the transmitted bits. In a prefered embodiment of the present invention the a-priori estimates of the transmitted bits are a-priori LLRs. The encoded codewords are transmitted by the transceiver via the data transmission channel 13 to a remote transceiver which decodes the encoded codewords by means of its LDPC decoder 1A.

Figure 15b shows a block diagram of the LDPC decoder 1A according to the present invention. The LDPC decoder 1A receives the a priori estimate values based on the channel observations from the demodulator via input 2A. The a priori estimates are either formed by a priori likelihood ratios (LLR) or a priori probabilities.

The a priori estimates are stored temporarily as initialization values in the random access memory 3 of the LDPC decoder 1A according to the present invention as shown in figure 15b. The QRAM-3 is provided for maintaining

the $Q_v$ messages.

The QRAM-3 is connected via a switching unit 4 to a processing block comprising Z generalized check node processors 5-i.

The serial decoding according to the present invention is inherently serial, however, sets of check nodes' messages can be updated in parallel. The check nodes are divided into sets $B_1;...; B_m$ such that no two check nodes c, c' in a set $B_i$ are connected to the same variable node, i.e.

$$\forall i \in \{1,...,m\} \forall c,c' \in B_i \qquad N(c) \cap N(c') = \emptyset \qquad (11)$$

Consequently the check nodes c in each set $B_i$ can be updated simultaneously. Since a fully parallel implementation is usually not possible due to the complex interconnection between the computation nodes c, the partially serial nature of the serial schedule is not limiting. In addition, when the check nodes c are divided into enough sets $B_i$, even if the sets $B_i$ do not maintain the above property (11), the performance of the LDPC-decoder 1A is very close to the performance of the serial schedule. Hence the serial schedule can be performed in a preferred embodiment by dividing the check nodes c into $m = \frac{M}{Z}$ equal sized sets $B_1;...; Bm$ of a size $Z$ and perform an iteration by updating all the check nodes c in set $B_1$ simultaneously, then updating all the check nodes in set $B_2$ simultaneously and so on until set $B_m$.

Generalized check node processor 5 according to the present invention as shown in figure 15b are provided for updating the messages between the nodes of the graph. The generalized check node processor 5 receive the $R_{cv}$ message from R-RAM 7 and are supplied with $Q_v$ messages from Q-RAM 3 via the switching unit 4. The generalized check node processor 5 calculate new updated values for the $R_{cv}$ and $Q_v$ messages. The updated $R_{cv}$ messages are stored back in the R-RAM 7 and the updated $Q_v$ messages are stored back in the Q-RAM 3 by means of the switching unit 4. The switching information for the switching unit 4 is read from a read only memory (ROM 6) wherein the LDPC code structure is stored. The Z generalized check node processors 5-i are provided for performing a simultaneous computation on the messages of Z check nodes. The decoding iteration performed by the generalized check node processors 5 consist of $\frac{M}{Z}$ steps wherein in each step messages of Z check nodes are processed by the Z generalized check node processor 5. A processor 5-i which is currently handling a check node c reads messages $Q_v$ and $R_{cv}$ for all $v \in N(c)$, performs computations and writes the updated messages back to the memories 3, 7. The reading of the messages $Q_v$, $R_{cv}$, the computation and the write back constitute three processing phases. Since a generalized check node processor 5 cannot complete these three processing phases in a single clock cycle in each generalized check node processor 5 a data processing pipe is provided. In an alternative embodiment the Q-RAM 3 and the R-RAM 7 allow simultaneous reading and writing. In this embodiment the generalized check node processor 5 read a new set of messages each clock cycle and write an already updated set of messages back with each clock. In this embodiment the decoding iteration will require M/Z clock cycles.

A generalized check node processor 5 outputs for the respective check node c of the bipartite graph an indicator $S_{sign}$ to check whether the LDPC decoder 1A has converged. As can be seen from figure 15b the generalized check node processors 5 forward the respective syndrome bits $S_{sign}$ to a converging testing block 8. A preferred embodiment of the converging testing block 8 is shown in figure 25. The converging testing block 8 realizes that the LDPC decoding process has converged and indicates this by outputting a success indication signal via output 9 of the LDPC decoder 1.

Figure 15b shows the general structure of an LDPC decoder 1A according to the present invention performing a serial schedule as shown in figure 9. The implementation of the LDPC decoders for random unstructured LDPC codes incurs high complexity. The decoder 1A according to the present invention, has even at a relatively low decoding rate many messages have to be read from the memories 3,7 and have to be written back to these memories 3, 7. Consequently this requires memories 3, 7 to be formed by multiport memories with complex addressing mechanism. Furthermore, a complex switching unit 4 is needed for routing messages from the memories 3, 7 to the generalized check node processors 5. To keep the implementation of the LDPC decoder 1A according to the present invention simple it is preferred to use structured architecture aware LDPC. This can simplify the addressing mechanism of the memories 3, 7 and the routing of the messages via switching unit 4. According to a preferred embodiment the LDPC decoder 1A uses a LDPC code which is based on lifted graphs resulting in parity-check matrices constructed from permutation matrices.

In the following the construction of LDPC codes based on lifted graphs resulting in parity check matrices composed of permutation matrices is described. This constructed LDPC codes simplify the implementation of the LDPC decoder 1 according to the present invention significantly.

When constructing a LDPC code of rate R and having a code length N with K=R*N information bits and with $M=(1-R)\cdot N$ parity check bits and a M*N parity check matrix H. The M*N parity check matrix H of the LDPC code is constructed from a $M_b*N_b$ block matrix $H_b$ wherein $M_b = \frac{M}{Z}$ and $N_b = \frac{N}{Z}$.

Each data entry into the block matrix is a Z*Z zero matrix or a Z*Z permutation matrix. The preferred embodiment is preferred to use a limited family of permutations that can be easily implemented.

The preferred embodiment the permutations are limited to cyclic permutations, denoted by $P^0,...,P^{Z-1}$, wherein

$$P^0 = \begin{pmatrix} 1 & 0 & \cdots & 0 \\ 0 & 1 & \cdots & 0 \\ \vdots & \vdots & \ddots & \vdots \\ 0 & 0 & \cdots & 1 \end{pmatrix} \text{ and } P^{Z-1} = \begin{pmatrix} 0 & 0 & \cdots & 0 & 1 \\ 1 & 0 & \cdots & 0 & 0 \\ 0 & 1 & \cdots & 0 & 0 \\ \vdots & \vdots & \ddots & \vdots & \vdots \\ 0 & 0 & \cdots & 1 & 0 \end{pmatrix}$$

The permutation size Z is a function of the latency or throughput required by the LDPC decoder 1A.

The underlying graph of the LDPC code constructed in this way can be interpreted using graph lifting. A small graph with $N_b$ variable nodes and $M_b$ check nodes is lifted or duplicated Z times, such that Z small disjoint graphs are obtained. Each edge of the small graph appears Z times. Then, each such set of Z edges is permuted among the Z copies of the graph, such that a single large graph with N variable nodes and M check nodes is obtained.

Figure 16 shows a simple example of a small [24, 12] LDPC code. Figure 16 shows the LDPC code before and after permutation. If the small $M_b x N_b$ graph represents an $(λ(χ),ρ(χ))$-irregular LDPC code then the derived large MxN graph also represents a $(λ(χ),ρ(χ))$-irregular LDPC code.

LDPC codes which are based on permutation block matrices, as described above enable a simple implementation of the LDPC decoder 1A supporting a high level of parallelism. A decoding iteration can be performed by processing $\frac{M}{Z}$ block rows of the parity check matrix H serially one after the other. Processing a block row of the matrix H with $d_c$ non-zero block entries, involves reading $d_c$ size Z blocks of $Q_v$ and $R_{cv}$ messages from the Q-RAM 3 and the R-RAM 7. The messages are then routed into Z generalized check node processors 5 that process the Z parity checks, corresponding to the block row, simultaneously. The updated messages are then written back into the memories 3, 7. Each set of Z $Q_v$ messages corresponding to a block column of the parity check matrix H is contained in a single memory cell of the Q-RAM 3. These messages are read together from the Q-RAM 3 and then routed into Z different generalized check node processors 5 by performing the appropriate permutation according to the H block matrix.

Figure 17 shows a first embodiment of the LDPC decoder 1A according to the present invention.

Figure 18 shows an example of the LDPC decoder 1A according to the first embodiment as shown in figure 17 for the parity check matrix H constructed as shown in figure 16.

In the example shown in figure 18 the LDPC decoder 1A is provided for small length 24 LDPC code. The initialization values of the R-RAM 7 and the Q-RAM 3 are also shown in figure 18.

Since a row of matrix H with $d_c$ non-zero block entries is processed in $d_c$ clock cycles, such that in each clock cycle the messages are read corresponding to a single non-zero block entry in the row, a decoding iteration is performed in $\frac{M*d_c}{Z}$ clock cycles.

If the LDPC decoder 1A according to the present invention is required to support a high decoder data rate a large number Z of generalized check node processors 5 is needed within the LDPC decoder 1A. This results in a very small $\frac{M}{Z} \times \frac{N}{Z}$ $H_b$

matrix which might produce a weak LDPC-codes due to limited level of freedom in designing the matrix H. Additionally, the generalized check processors 5 cannot finish processing of the check procedure until all $d_c$ messages have been read into the processors 5. Consequently the execution pipe of each generalized check node processor 5 is at least $d_c$, which can be high for high rate codes. This can increase the amount of registers required for the execution pipe of each processor 5 substantially and consequently result in an increased logic area and increased decoder power consumption.

Provided that the row degree in matrix H is constant (or almost constant) these disadvantages can be avoided if additional structure is incorporated into the H matrix which enables reading of all the $d_c$ blocks of Z messages simultaneously from $d_c$ different RAM units. This way each row of the H matrix is processed in a single clock cycle so that a decoding iteration takes $\frac{M}{Z}$ clock cycles allowing for a smaller permutation block size Z and as a result a bigger block matrix $H_b$ and an increased degree of freedom in designing $H_b$. Furthermore the length of the execution pipe of each generalized check node processor 5 is no longer a function of $d_c$ so that it can be much smaller.

In a preferred embodiment in order to support simultaneous reading all row messages in a single clock cycle additional structure is incorporated into the H matrix of the LDPC code. In a preferred embodiment the parity-check matrix H LDPC code is constructed in the following manner. The block columns of the parity-check matrix H is devided into $d_c$ sets (or more than $d_c$ sets, however not more than $N_b$ sets). Each block row of the parity-check matrix H is required to contain $d_c$ non-zero block entries from $d_c$ different sets. This makes it possible to divide the $Q_v$ messages into $d_c$ Q-RAMS 7 (or even more) according to the division of the block columns of the parity-check matrix H into $d_c$ (or more) sets. As a consequence it is ensured when a block row of the parity check matrix H is processed the $d_c$ sets of Z $Q_v$ messages that need to be read are stored in different $d_c$ (or more) RAM units and can be read together (without the need for provision of a mult-port RAM). The corresponding architecture of the LDPC decoder 1A forms a second embodiment as shown in figure 21.

When comparing the LDPC decoder 1A according to the first embodiment of the present invention as shown in figure 17 with the second embodiment of the LDPC decoder 1A as shown in figure 21 the LDPC decoder 1A according to the first embodiment has an increased complexity and consequently needs more chip area. Furthermore the LDPC decoder 1A according to the first embodiment of figure 17 has an increased power consumption when compared to the LDPC decoder 1A of the second embodiment as shown in figure 21 because the LDPC decoder 1A of the first embodiment has more registers in the execution pipe of the processors 5. In contrast the main advantage of the LDPC decoder 1A according to first embodiment of the present invention as shown in figure 17 is that it is more generic then the LDPC decoder 1A of the second embodiment as shown in figure 21. The reason for that is that the LDPC decoder 1A according to the first embodiment of figure 17 is not restricted in that the check node degree $d_c$ is fixed. Consequently the LDPC decoder 1A is also able to decode the LDPC code with various check node degrees while remaining efficient.

In both embodiments the LDPC decoder 1A the Q-RAM 3 and the R-RAM 7 are read from and written to in each clock cycle. Therefore the RAM memories are formed by a two port RAM. The complexity of the R-RAM 7 which is generally a large RAM can be reduced in both embodiments of LDPC decoder 1A by taking into account the sequential addressing of the R-RAM 7. Since no random access is needed a memory with a simplified addressing mechanism and reduced complexity can be used employing sequential addressing. Furthermore, due to the sequential addressing the R-RAM 7 can be partitioned in a preferred embodiment into two RAMs, wherein one R-RAM 7a contains the odd addresses and the other R-RAM 7b contains the even addresses. Accordingly in each clock cycle messages are read from one R-RAM and messages are written back to the other R-RAM. In this preferred embodiment a low complexity single port RAM can be used for the R-RAM 7.

In the following possible implementations of generalized check node processors 5 for both embodiments are described. A BP generalized check node processor 5 which is currently handling a check node c reads the messages $Q_v$ and $R_{cv}$ for all $v \in N(c)$ and performs the following computations :

$$S \leftarrow \sum_{v \in N(c)} \varphi(Q_v - R_{cv})$$
$$\text{for all } \upsilon \in N(c)$$

$$Q_{temp} \leftarrow Q_\upsilon - R_{c\upsilon}$$
$$R_{c\upsilon} \leftarrow \varphi^{-1}(S - \varphi(Q_{temp}))$$
$$Q_\upsilon \leftarrow Q_{temp} + R_{c\upsilon}$$
$$\text{end of loop}$$

The check node processor writes the updated messages back to the memories 3, 7.

Note that the generalized check node processor 5 implements in alternative embodiments a computation rule different from BP (Belief Propagation).

For example the check node processor implements the suboptimal, low complexity Min-Sum computation rule as follows:

$$\text{for all } \upsilon \in N(c)$$
$$Q_{\upsilon c}^{temp} \leftarrow Q_{\upsilon} - R_{c\upsilon}$$
$$\text{end of loop}$$

$$\text{for all } \upsilon \in N(c)$$
$$R_{c\upsilon} \leftarrow \prod \upsilon' \in N(c)/\upsilon (-1)^{sign(Q_{\upsilon'c}^{temp})} \min \upsilon' \in N(c)/\upsilon \left\{ Q_{\upsilon'c}^{temp} \right\}$$
$$Q_{\upsilon} \leftarrow Q_{\upsilon c}^{temp} + R_{c\upsilon}$$
$$\text{end of loop}$$

A schematic circuit-diagram of a BP generalized check node processor 5 for embodiment 1 is shown in Figure 20.

A schematic circuit-diagram of a BP generalized check node processor 5 for embodiment 2 is shown in Figure 22.

The implementation of the QR-block and S-block are shown in Figures 23 and 24.

The $\varphi$ and $\varphi^{-1}$ transforms are preferably implemented using LUT's. In a preferred embodiment of the BP generalized check node processor the computation with LLR's is performed in 2's complement representation and computations with $\varphi$ (*LLR*) are done in sign/magnitude representation. The messages are saved as LLR's in 2's complement representation. All computations performed between the $\varphi$ and $\varphi^{-1}$ transforms are performed in sign/magnitude representation. The conversion between the two representations can be incorporated into the $\varphi$ and $\varphi^{-1}$ transforms.

Since in the LDPC decoder 1A the saving of the $Q_{vc}$- messages is avoided they are computed on the fly according to:

$$Q_{vc} = Q_{temp} = Q_v - R_{cv}$$

In a fixed point implementation the $Q_v$ messages have in a preferred embodiment a greater dynamic range than the $R_{cv}$ messages in order to avoid loosing the $Q_{vc}$ information. It is sufficient to represent the $Q_v$ messages using an additional bit. However, as a consequence, once a $Q_v$ message has reached its maximal value, it should not be updated any more. This is maintained using the "Check Saturation" block shown in Figures 20 and 23. This turns out to be an advantage since it reduces the logic power consumption.

Unlike the standard flooding schedule where convergence testing is performed at the end of each iteration by computing the syndrome, the serial schedule according to the present invention allows for a simple convergence checking during the decoding process. This is done as a by product of the decoding process by checking that the sign bit of the S variables in all the processors 5 are positive for $\frac{M}{Z}$ consecutive clocks, as shown in Figure 25. Once convergence is detected, the execution pipe of the processor 5 is emptied and the sign bits of the $Q_v$ variables residing in the Q-RAM 3 constitute the decoded codeword. The convergence testing mechanism is incorporated into the controller unit 9 shown in Figures 17 and 21.

For the LDPC-decoder 1A to the first embodiment implementing various code rates R and code lengths N on the same hardware is done by storing various matrices H in the ROM 6. Since the block matrix description is very concise, the overhead of maintaining several matrices is small.

In the second embodiment of the LDPC decoder 1A a fixed check node degree $d_c$ is assumed. The node degree $d_c$ is set according to the highest code rate that has to be supported and which has the highest check node degree. Then lower code rates are implemented by nullifying some of the $d_c$ check node processor inputs.

An alternative for implementing several code rates R on the same hardware, which can be used for both LDPC-decoder embodiments is to derive the various code rates from a single block matrix $H_b$ through row merging. Higher rate LDPC-codes are constructed from one single basic block matrix $H_b$ by summing up block rows of the matrix $H_b$ which have no non-zero overlapping block entries. This results in a smaller dimension parity check matrix H corresponding to a higher rate code. For instance when using a basic LDPC-code of code-rate 1/2 constructed from a $\frac{N}{2Z} x \frac{N}{Z}$

block matrix $H_b$ the matrix is designed, such that block row i and block row $i+\frac{N}{4Z}$ for 4Z $i=1,...,\frac{N}{4Z}$ have no overlapping non-zero block entries. Then the block rows of *H are* divided into pairs, i.e., match block row *i* with block row $i+\frac{N}{4Z}$ for $i=1,...,\frac{N}{4Z}$ .Then by summing up $\alpha$ of the pairs of block rows together, where $\alpha$ is a number between 1 and $\frac{N}{4Z}$, a smaller $N\frac{N}{2Z}-\alpha\times\frac{N}{Z}$ block matrix $H_b$ corresponding to a rate

$$\left(1/2+\frac{\alpha Z}{N}\right)$$

LDPC-code is achieved. This way LDPC codes for any rate between 1/2 and 3/4 can be obtained. This construction of a higher rate LDPC-code from the basic LDPC-code is advantageous because the constructed LDPC-code can be decoded using the same decoder hardware. A row in the new parity-check matrix H which is a result of summing up a pair of block rows in the basic parity-check matrix H is processed by reading the messages corresponding to the two block rows into the processor 5 in two clocks, such that the processor 5 regards all messages as if they belong to the same check. The mechanism required for supporting row merging is incorporated into the S-block and QR-block shown in Figure 23 and Figure 24. The control signal *MergeRows* shown in Figures 23,24 and 25 enable the row merging each time two consecutive rows are merged. The processing of a merged row takes twice the time (two clock instead of one), however the number of rows to process is reduced accordingly, hence the decoding time remains the same. The advantage of this method is that a single matrix is used for deriving many code rates R, however, the derived LDPC-codes are not optimal.

Various code rates R and code lengh N can also be supported using a shortening and puncturing mechanism or a combination of shortening and puncturing. Shortening lowers the code rate R and puncturing increases the code rate R. At the LDPC-encoder 1B, shortened bits (which are information bits) are set to zero and then encoding is performed. The shortened and punctured bits are not transmitted. At the LDPC-decoder 1A, shortened bits are initialized with the "0" message (zero sign bits and maximal reliability) and punctured bits are initialized with the erasure message (don't care sign bit and zero reliability), then decoding is performed. The decoding time for the shortened/punctured LDPC-codes remains the same as the decoding time of the complete LDPC-code (since the LDPC-decoder 1 works on the complete code) even though the LDPC-codes are shorter.

Various code length N can be obtained by deflating the $Z\times Z$ permutation blocks, hence deflating the code's parity-check matrix H . In this way LDPC codes of length $\frac{N}{Z}$ , $2\frac{N}{Z}$ ,..., N can be obtained. For example if a LDPC code of length $\frac{N}{2}$ is to be obtained the block matrix $H_b$ is constructed of permutation blocks of size $\frac{Z}{2}\times\frac{Z}{2}$ . This means that at the LDPC-decoder 1, each Q-RAM memory cell contains only $\frac{Z}{2}$ messages out of the Z messages and only $\frac{Z}{2}$ processors 5 are used for the decoding. Similar to the shortening/puncturing method, the decoding time of short LDPC codes remains the same as the decoding time of the basic LDPC code. In a streaming mode this can be avoided by utilizing the unused hardware for decoding of the next codeword.

In order to achieve a decoding time which is linear with the code length N, additional smaller H block matrices are used for the shorter LDPC-codes, such that all matrices contain $Z\times Z$ permutation blocks. Thus, implementing each additional code length N requires only an additional ROM 6 for maintaining the *H* matrix (which requires a small ROM due to its concise description), and no changes in the hardware of the LDPC-decoder 1A is needed.

By enforcing additional structure on the constructed LDPC-code a linear encoding complexity can be achieved. The constructed LDPC-code is systematic such that the first $K_b =\frac{K}{Z}$ blocks contain information bits and the last $M_b$ blocks contain parity-check bits. The last $M_b$ block columns of *H* form a block lower triangular matrix or almost a block lower triangular matrix. In order to support simple encoding of various codes rates R that are obtained by row merging as explained above the last $M_b$ block columns of the matrix *H* can have the structure as shown in Figure 26. Where, $M_1 \leq M_2$ and $M_{b1} = M_1/Z$ is equal to the maximal number of block rows that are merged to generate the highest rate code supported.

Figure 27 shows a preferred embodiment of the LDPC encoder 1B within the transceiver as shown in figure 15a. Comparing figure 27 with 15b showing the architecture of the LDPC decoder 1A it can be seen that the LDPC encoder 1B according to the present invention is implemented by the same hardware.

The LDPC encoder 1B comprises a RAM 3, a switching unit 4, an array of generalized check node processors 5 and a read-only memory 6. The provision of a RAM 7 and a conversion testing unit 8 is not necessary. Since the LDPC encoder 1B and the LDPC decoder 1A are performed by the same hardware it is possible to form the encoder/decoder 1 either by providing two units 1A, 1B as shown in figure 15a connected in parallel, wherein the first unit 1A performs the decoding process whereas the other unit 1B performs the encoding process. In an alternative embodiment the unit having the circuit structure as shown in figure 15b is switched between an encoding mode for performing the encoding process and a decoding mode for performing the decoding process. This embodiment has the advantage that less circuitry has to be implemented on the chip. Even when implementing the FEC-layer 1 by providing a separate LDPC encoder 1B and a separate LDPC decoder 1A having the same hardware it is advantages that both units are formed on the basis of the same hardware when designing the chip.

In the following a preferred embodiment to perform the encoding is described wherein i=[$i_1$ $i_2$ ... $i_{Kb}$] denotes the information bits block divided into Kb sets of $Z$ bits, i.e. $i_j = [i_{j;1} ... i_{j;z}]^T$ is a column of $Z$ consecutive information bits, wherein p = [$p_1$ $p_2$ ... $p_{Mb}$] denotes the parity bits block divided into $M_b$ sets of Z bits, i.e. $p_j=[p_{j;1} ... p_{j;z}]^T$ is a column of $Z$ consecutive parity bits,

wherein c = [i p] denotes the codeword block divided into $N_b$ sets of $Z$ bits and wherein
$A(i; j)$ denotes the $(i; j)$ $Z{\times}Z$ block of a block matrix $A$ shown in figure 26.

Encoding is performed by the LDPC encoder 1B shown in figure 27 as follows:

1. Compute

$$p_j= \sum_{l=1}^{K_b+j-i} A(j,l)c_l \qquad \text{for } j=1, \ldots, M_{b1}$$

2. Compute

$$s_j = \sum_{l=1}^{K_b+M_{b1}} B(j,l)c_l \qquad \text{for } j=1, \ldots, M_{b2}$$

3. Compute

$$p_{M_{b1+1}} = \sum_{j=1}^{M_{b2}} s_j$$

4. Compute

$$p_{M_{b1+2}} = s_1 + T(1,1)p_{M_{b1+1}}$$

5. Compute

$$p_{M_{b1+j+1}} = s_j + T(j,1)p_{M_{b1+1}} + p_{M_{b1+j}} \qquad \text{for } j=2, \ldots, M_{b2}-1.$$

The same data path that is used by the LDPC-decoder 1A can be used for LDPC-encoder 1B. Hence, encoding can be performed on the same hardware used for the LDPC-decoder 1A.

If the LDPC-code is constructed using a lower triangular $H_b$ matrix then encoding can be performed using the decoder. The $Q_v$ messages corresponding to the $K$ information bits are initialized with information bits ($\pm$ the largest $Q_v$ message value, indicating total reliability of the bit) and the $Q_v$ messages corresponding to the M parity bits are initialized with erasures (zero value - indicating no reliability). Decoding is performed and the erased parity-check bits are recovered after a single iteration.

In order to reduce the power consumption, the computations performed during the encoding are preferably done only on the sign bit of the messages, since encoding requires only xor operations. The processors 5 can distinguish between erased bits and known bits using the bits that represent the message's magnitude. Then, encoding is simply performed by applying the following rule: each processor 5 reads only one unknown bit and sets the unknown bit to be. the xor of all other known bits in the check (the xoring mechanism already exists in the processors).

The hardware required for implementing a LDPC encoder-decoder system 1 depends from the code parameters, system parameters and the required performance. Performance is measured as the number of iterations that the LDPC-decoder 1 is allowed to perform under given latency or throughput limitations. BP decoding is assumed.

Basic code parameters:

$N$ - code length
$d_v$ - average bit degree (average number of checks a bit participates in - usually $d_v \cong 3.5$)
$R_{max}$ - maximal code rate supported by the system.
$d_c$ - maximal check degree

For right regular codes:

$$d_c = \frac{d_v}{1 - R_{max}}.$$

Encoder-Decoder parameters:

$f_c$ - Encoder-Decoder clock [Mhz]
$bpm$ - bits per message
$bpm_2$ - bits per message after $\varphi$ transform
$Z$ - number of processors 5 for embodiment 1, or number of QR-blocks for embodiment 2.

$Z_2 = \frac{Z}{d_c}$ - number of processors in embodiment 2.

Decoder performance

$R_{ch}$ - channel bit rate (uncoded) [Mbps]

$Istreaming = \frac{Zf_c}{d_v R_{ch}}$ - number of iterations supported at streaming mode.

L - Maximal decoding latency [µsec]

$$I_L = \min\left\{\frac{LZf_c}{Nd_v}, I_{streaming}\right\} - \text{number of iterations supported with}$$

decoding latency $L$.

Encoder-Decoder complexity of the first embodiment

Logic: BP processors ~ $Z$0.6Kgates
RAM:

1. R-RAM 7: $(\frac{Nd_v}{Z}) \times (Zbpm)$ bits two port RAM with reduced addressing requirements (addresses are read/written sequentially)

2. Q-RAM 3:

$$\left(\frac{N}{Z}\right) \times \left(Z(bpm+1)\right)$$

bits two port RAM

3. $Zx((9+d_c)(bpm+1)+(3+d_c)bmp_2)$ 1bit registers for pipe buffering and read/write permutation buffers.

ROM 6: $\dfrac{Nd_\upsilon}{Z} \times ([\log_2(N)]+1)$ address ROM

Encoder-Decoder complexity of the second embodiment

Logic: BP processors - ~$Z$0.6Kgates
RAM:

1. R-RAM 7:

$$\left(\frac{Nd_\upsilon}{Z}\right) \times (Zbpm)$$

bits two port RAM with reduced addressing requirements (addresses are read/written sequentially)

2. Q-RAM 3: $d_c$ two port RAM units, each one of size $\dfrac{N}{Z} \times \dfrac{Z}{d_c}$ ($bpm$+1) bits

3. $Z \times (12(bpm+1)+6bpm_2-2)$ 1bit registers for pipe buffering and read/write permutation buffers.

ROM 6:

$$\frac{Nd_\upsilon}{Z} \times d_c \left(\left[\log_2\left(\frac{N}{d_2}\right)\right]+1\right)$$

address ROM

The RAMs that are used are Two-Port RAMs (TPRAM). For the R-RAM 7 a single port RAM can be used.

**Claims**

**1.** LDPC decoder for decoding a codeword (Y) received from a communication channel as the result of transmitting a Low Density Parity Check (LDPC) codeword (b) having a number (N) of codeword bits which consists of K information bits an N parity check bits, wherein the product of the LDPC codeword (b) and a predetermined (MxN) parity check matrix H is zero ($H*b^T=0$) wherein the (MxN) parity check matrix H represents a bipartite graph comprising N variable nodes (V) connected to M check nodes (C) via edges according to matrix elements $h_{ij}$ of the parity check matrix H,
wherein the LDPC decoder (1A) comprises:

(a) a memory (3) for storing for each codeword bit of the received noisy codeword (Y) a priori estimates (Qv) that said codeword bit has a predetermined value from the received noisy codeword (Y) and from predetermined parameters of the communication channel;

(b) generalized check node processing units (5) for calculating iteratively messages on all edges of said bipartite graph according to a serial schedule,

wherein in each iteration, for each check node (C) of said bipartite graph, for all neighboring variable nodes (V) connected to said check node (C) input messages ($Q_{VC}$) to said check node (C) from said neighboring variable nodes (V) and output messages ($R_{CV}$) from the check node (C) to said neighboring variable nodes (V) are calculated by means of a message passing computation rule.

2. LDPC decoder according to claim 1,
   wherein the LDPC decoder(1A) comprises a read only memory (6) for storing at least one bipartite graph.

3. LDPC decoder according to claim 1,
   wherein the LDPC decoder (1A) comprises a further memory (7) for storing temporarily the check to variable messages ($R_{CV}$).

4. LDPC decoder according to claim 1,
   wherein the LDPC decoder (1A) comprises a convergence testing block (8) which indicates whether the decoding process has converged successfully.

5. LDPC-decoder according to claim 1
   wherein the bipartite graph is a Tanner graph.

6. LDPC-decoder according to claim 1
   wherein the message passing computation rule is a belief propagation (BP) computation rule.

7. LDPC-decoder according to claim 1
   wherein the message passing computation rule is a Min-Sum computation rule.

8. LDPC-decoder according to claim 1
   wherein the calculated a-priori estimates are log-likelihood ratios (LLRs).

9. LDPC-decoder according to claim 1
   wherein the calculated a-priori estimates are probabilities.

10. LDPC-decoder according to claim 1
    wherein a decoding failure is indicated by said LDPC-decoder (1A) when the number of iterations reaches an adjustable threshold value.

11. LDPC-decoder for decoding a noisy codeword (y) received from a noisy communication channel as a result of transmitting through the communication channel a codeword (b) having a number (N) of codeword bits which belongs to a length (N) low-density parity-check code for which a (MxN) parity check matrix (H) is provided and which satisfies $H*b^T=0$, wherein the parity-check matrix H is represented by a bipartite graph comprising N variable nodes (V) connected to M check nodes (C) via edges according to matrix elements $h_{ij}$ of the parity check matrix H, wherein the LDPC decoder (1A) comprises:

    (a) an input (2A) for receiving an a priori estimate ($Q_v$) for each codeword bit (V) of said transmitted LDPC codeword (b) that the codeword bit (V) has a predetermined value from the received noisy codeword (Y) and from predetermined parameters of said communication channel;

    (b) a first memory (3) for storing the calculated a priori estimates ($Q_v$) for each variable node (V) of said bipartite graph, corresponding to a codeword bit (V), as initialization variable node values;

    (c) a second memory (7) for storing check-to-variable messages ($R_{CV}$) from each check node (c) to all variable nodes (V) of said bipartite graph initialized to zero;

    (d) wherein generalized check node processors (5) calculate iteratively messages on all edges of said bipartite graph according to a serial schedule, in which at each iteration, all check nodes (c) of said bipartite graph are serially traversed and for each check node (C) of said bipartite graph the following calculations are performed by a corresponding generalized check node Processor (5-i):

(d1) reading from the first memory (3) stored messages ($Q_v$) and from the second memory (7) stored check-to-variable messages ($R_{CV}$) for all neighboring variable nodes (V) connected to said check node (c);

(d2) calculating by means of a message passing computation rule, for all neighboring variable nodes (V) connected to said check node (C) variable-to-check messages ($Q_{VC}$) as a function of the messages ($Q_v$) and the check-to-variable messages ($R_{CV}$) read from said memories (3 ; 7) ;

(d3) calculating by means of a message passing computation rule, for all neighboring variable nodes (V) connected to said check node (C) updated check-to-variable messages ($R_{CV}^{new}$) as a function of the calculated variable-to-check message ($Q_{VC}$);

(d4) calculating by means of a message passing computation rule, for all neighboring variable nodes (V) connected to said check node (C) updated a-posteriori messages ($Q_v^{new}$) as a function of the former ($Q_V$) messages and the updated check-to-variable messages ($R_{CV}^{new}$) ;

(d5) wherein the updated a posteriori messages ($Q_V^{new}$) and updated check-to-variable messages ($R_{CV}^{new}$) are stored back into said memories (3; 7) ;

(d6) calculating a decoded estimate codeword (b*) as a function of the a-posteriori messages (Q) stored said first memory (3) ;

(e) a convergence testing unit (8) for checking whether the decoding has converged by checking if the product of the parity check matrix H and the decoded estimate (b*) codeword is zero ;

(f) an output (10A) for outputting the decoded estimate codeword (b*) once the decoding has converged or once a predetermined maximum number of iterations has been reached.

12. LDPC-decoder according to claim 2 wherein the read only memory (6) stores several bipartite graphs for different LDPC codes.

13. LDPC-decoder according to claim 13 wherein the LDPC-decoder (1A) is switchable between different LDPC codes.

14. LDPC-decoder according to claim 14 wherein the LDPC codes comprise different code rates (R).

15. LDPC-decoder according to claim 1 wherein the LDPC-decoder (1A) is a multi rate decoder for decoding LDPC codes having different code rates (R).

16. LDPC decoder according to claim 11, wherein a switching unit (4) is provided for routing messages from said memories (3, 7) to said generalized check node processors (5).

17. LDPC decoder according to claim 16, wherein the parity check matrix (H) is constructed from permutation blocks such that the routing of messages between the memory (3) and the generalized check node processors (5) is simplified.

18. LDPC decoder according to claim 11, wherein each generalized check node processing unit (5) comprises at least one QR block (5a) for updating the $Q_V$ and the $R_{CV}$ messages and an S block (5b) for computing a soft parity check (S).

19. LDPC decoder according to claim 18, wherein the QR block (5a) and the S block (5b) perform row merging in response to a control signal.

20. LDPC decoder according to claim 11, wherein the first memory (3) is formed by a two port random access memory (TPRAM).

21. LDPC decoder according to claim 11, wherein the second memory (7) is formed by a random access memory (RAM).

**EP 1 610 466 A1**

22. LDPC decoder according to claim 21, wherein the second memory (7) is partitioned into a first single port RAM (7a) containing odd addresses and in a second single port RAM (7b) containing even addresses.

23. LDPC decoder according to claim 21, wherein the second memory (7) is a two port random access memory (TPRAM).

24. LDPC decoder/encoder (1) comprising
an LDPC decoder (1A) according to claim 1 and
an LDPC encoder (1B) having the same hardware structure as the LDPC decoder (1A).

25. LDPC decoder according to claim 11, wherein each generalized check node processing unit (5) comprises a check saturation block so that the $Q_V$ messages are storable with only one additional bit.

26. LDPC decoder according to claim 11,
wherein the switching unit (4) performs various size permutations enabling decoding of variable length codes.

27. LDPC decoder according to claim 12,
wherein various rate codes are decodable by means of row merging of rows in the parity check matrix (H) stored in the read only memory (6) in response to a row merging control signal.

28. LDPC encoder (1B),
wherein a codeword is encoded by said LDPC encoder (1B) directly from a parity check matrix (H) stored in a memory thus enabling encoding of variable rate codes using the same hardware.

29. LDPC encoder (1B),
wherein a codeword (y) is encoded by multiplying an information bit vector (i) with a (KxN) generator matrix G, wherein the product of said generator matrix G and the transposed parity check matrix $H^T$ is zero ($G*H^T=0$).

23

# FIG 1

## Prior Art

constraints on the codeword bits

Variables

$$v_2 \oplus v_4 \oplus v_{11} \oplus v_{13} = 0$$

Checks

Sparse parity-check matrix $H_{<M \times N>}$

Variable nodes

Check nodes

$$v_6 \oplus v_8 \oplus v_9 \oplus v_{10} = 0$$

Sparse bipartite graph

# FIG 2

N=4                    M=2

bipartite Tanner graph

$$H = \begin{bmatrix} 1 & 1 & 1 & 0 \\ 1 & 0 & 1 & 1 \end{bmatrix}$$

$$G = \begin{bmatrix} 1 & 0 & 1 & 0 \\ 0 & 1 & 1 & 1 \end{bmatrix}$$

# FIG 3

Transceiver

$\underline{i} = [1\ 0]$

LDPC Encoder
$\underline{b} = \underline{i}G$

$\underline{b} = [1\ 0\ 1\ 0]$

Modulator
$b=0 \rightarrow x=1$
$b=1 \rightarrow x=-1$

$\underline{x} = [-1\ 1\ -1\ 1]$

$$f(Y\,|\,X=\pm 1) = \frac{1}{\sqrt{\pi N_0}}\,e^{-\frac{(y\pm 1)}{N}}$$

biAWGN Channel
$N_0 = 8$

$-1 \quad 1$

$\widehat{\underline{b}} = [1\ 0\ 1\ 0]$

$\widehat{\underline{i}} = [1\ 0]$

Transceiver

LDPC Decoder

Decoding success

Demodulator

$4/N_0 \blacktriangleleft MF$

$\underline{y} = [-1.4 \quad 1.8 \quad -3.3 \quad -1.2\ ]$

$\underline{P} = [-0.7 \quad 0.9 \quad -1.65 \quad -0.6]$

$$P_j = \ln\left(\frac{\Pr(y_j\,|\,x_j = 1)}{\Pr(y_j\,|\,x_j = -1)}\right) = \frac{4}{N_0}\,y_j$$

Flow chart for a
Belief-Propagation
Decoder based on the
flooding schedule

n - number of variable nodes (code length)
m - number of check nodes (parity - check matrix dimension)
$V = \{0,..., n-1\}$ variable nodes
$C = \{0,..., m-1\}$ check nodes
$N(c)$ - the set of neighboring nodes of node c.
Maxiter - maximal number of iterations that the decoder
is allowed to perform

**FIG 4**
Prior art

FIG 5
Prior Art

BP decoding using the standard flooding decoder

28

Standard Message-Passing decoder architecture based on flood scheduling

FIG 6
Prior Art

E - number of edges in the code's graph H
N - codeword length
E -= 3.5N

EP 1 610 466 A1

# FIG 7

Check node processor

$\{v_1, v_2, ..., v_d\} \in N(c)$

$d_c$ - the degree of check node c

$\varphi$ and $\varphi^{-1}$ transforms can be implemented using Look Up Tables (LUT's)

Prior Art

EP 1 610 466 A1

# FIG 8
## Prior Art

variable node     $\{c_1, c_2, ..., c_d\} \in N(v)$
processor         $d_v$ – the degree of symbol node $v$

EP 1 610 466 A1

Flow chart for an
efficient implementation
Belief-Propagation
decoder based on
the serial schedule

n - number of variable nodes (code length)
m - number of check nodes (parity - check matrix dimension)
$V = \{0,..., n - 1\}$ variable nodes
$C = \{0,..., m - 1\}$ check nodes
$N(c)$ - the set of neighboring nodes of node c.
Maxiter - maximal number of iterations that the decoder
is allowed to perform

$$\underline{b}$$
Transmitted codeword

Channel
$Pr(y \,|\, b)$

$\underline{y}$ - received channel observations

initialization

Example: binary input AWGN channel with single sided spectral noise power $N_0$:

$$Q_V = \frac{4}{N_0} y_v$$

Set:

$$Q_V = \log\left(\frac{Pr(y_v \,|\, b_v = 0)}{Pr(y_v \,|\, b_v = 1)}\right) \quad \forall v \in V$$

$$R_{CV} = 0 \qquad \forall c \in C, \forall v \in V$$

S1 — $i = 0$
valid $= 0$

S2 — $c = i \bmod m$

Generalized check node BP processor

for all $v \in N(c)$

$$Q_{VC}^{temp} = Q_V^{old} - R_{CV}^{old}$$

$$S = \sum_{v \in N(c)} \varphi(Q_{VC}^{temp})$$

for all $v \in N(c)$

$$R_{CV}^{new} = \varphi^{-1}(S - \varphi(Q_{VC}^{temp}))$$

$$Q_V^{new} = Q_{VC}^{temp} + R_{CV}^{new}$$

S3

Update messages:

$Q_V^{old}, R_{CV}^{old} \forall v \in N(c)$ → Generalized check node BP processor → $Q_V^{new} R_{CV}^{new} \forall v \in N(c)$

$S_{sign}$ - indicator if check is valid

S4 —

$i = i + 1$
if $S_{sign} = 1$
valid $= 0$
else
valid $=$ valid $+ 1$

$i = i + 1$
if $i \bmod m = 0$
$\hat{\underline{b}} = \text{sign}(\underline{Q})$, $\underline{s} = H\underline{b}$
valid $= \sum_{i-1}^{m} (1 - s_i)$

2 alternative convergence testing procedures

S5 — $(i/m \geq \text{Maxiter})$ or $(\text{valid} = m)$?   No

S6 — $(\text{valid} = m)$?   No — Decoding Failed!

Yes

$\hat{\underline{b}} = \text{sign}(\underline{Q})$

# FIG 9

# FIG 10

BP decoding using the efficient serial decoder

Flow chart for an
efficient implementation
of a general Message-
Passing decoder based
on the serial schedule

n – number of variable nodes  (code length)
m – number of check nodes (parity - check matrix dimension)
$V = \{0,..., n-1\}$ variable nodes
$C = \{0,..., m-1\}$ check nodes
$N(c)$ – the set of neighboring nodes of node c.
Maxiter – maximal number of iterations that the decoder
is allowed to perform

$\underline{b}$
Transmitted
codeword

Channel

$\underline{y}$ - received channel observations

initialization

Set:
$Q_v = $ function $(y_v)$      $\forall v \in V$
$R_{cv} = 0$      $\forall c \in C, \forall v \in V$
$i = 0$
S1
valid $= 0$

Paralllelism: sets of
check nodes that have
no common neighboring
variable nodes can
be updated simultaneously

S2   $c = i \bmod m$

S3

Update  messages:

$Q_y^{old}, R_{cv}^{old} \forall v \in N(c)$

Generalized
check node
processor

$Q_v^{new}, R_{cv}^{new} \forall v \in N(c)$

$S_{sign}$ -indicator if
check is valid

$i = i + 1$
if $S_{sign} = 1$
S4
valid $= 0$
else
valid $=$ valid $+ 1$

$i = i + 1$
if $i \bmod m = 0$
$\hat{\underline{b}} = sign(\underline{Q}), \underline{s} = H\underline{b}$
valid $= \sum\limits_{j-1}^{m} (1-s_j)$

2 alternative
convergence
testing
procedures

S5

(i/m ≥ Maxiter) or
(valid $= m$)?

No

S6    Yes

(valid $= m$)?

No

Yes

Decoding
Failed!

$\hat{\underline{b}} = sign(\underline{Q})$

# FIG 11

# FIG 12

| Flood scheduling: | Efficient serial scheduling: |
|---|---|
| initilization:<br>for all $v \in V$, $c \in C$    $R_{cv} \leftarrow 0$<br>for all $v \in V$, $c \in C$    $Q_{vc} \leftarrow P_v$<br><br>iteration:<br>for all $c \in C$<br>for all $v \in N(c)$<br>$R_{cv} \leftarrow \varphi^{-1}(\Sigma_{v' \in N(v) \backslash c} \varphi(Q_{c'v}))$<br>end of loop<br>end of loop<br><br>for all $v \in V$<br>for all $v \in N(v)$<br>$Q_{vc} \leftarrow P_v + \Sigma_{c' \in N(v) \backslash c} R_{c'v}$<br>end of loop<br>end of loop<br><br>for all $v \in V$<br>$Q_v \leftarrow P_v + \Sigma_{c' \in N(v)} R_{cv}$<br>end of loop | initilization:<br>for all $v \in V$, $c \in C$    $R_{cv} \leftarrow 0$<br>for all $v \in V$    $Q_v \leftarrow P_v$<br><br>iteration:<br>for all $c \in C$<br>$s \leftarrow \Sigma_{v \in N(c)} \varphi(Q_v - R_{cv})$<br>for all $v \in N(c)$<br>$Q_{temp} \leftarrow Q_c - R_{cv}$<br>$R_{cv} \leftarrow \varphi^{-1}(S - \varphi(Q_{temp}))$<br>$Q_v \leftarrow Q_{temp} + R_{cv}$<br>end of loop<br>end of loop |

Flood and Serial decoding algorithms

# FIG 13A

# FIG 13B

Simulation results for a length 2400, irregular $(0.1316x + 0.5365x^2 + 0.3319x^7 , x^6)$-
LDPC code over the Gaussian channel with maximum of 10 iterations:
(a) average iterations vs. Eb/No    (b) Block Error Rate vs. Eb/No

N = 2400, M = 1200, BP Decoding
with maximum of 10 iterations

flooding schedule
serial-V schedule
serial-C schedule

N = 2400, M = 1200, BP Decoding
with maximum of 10 iterations

flooding schedule
serial-V schedule
serial-C schedule

EP 1 610 466 A1

## FIG 14B

Simulation results for a length 2400, irregular $(0.1316x + 0.5365x^2 + 0.3319x^7, x^6)$-
LDPC code over the Gaussian channel with maximum of 50 iterations:
(a) average iterations vs. Eb/No    (b) Block Error Rate vs. Eb/No

## FIG 14A

N = 2400, M = 1200, BP Decoding
with maximum of 50 iterations

# FIG 15A

EP 1 610 466 A1

# FIG 15B   Efficient Message-Passing decoder architecture based on serial scheduling

Initialized with channel LLR's from demodulator -Pv messages — 2A

1A

Generalized Check node processors

4 switch

5 — P1, P2, ... Pz

3

10A

RAM for Qv messages (size: N messages)

Decoded codeword b = sign bits of the Qv messages

RAM for Rcv messages (size: E messages) — 7

Provide memory addressing and switching information

$s_{sign}$ ← ─ ─ ─ ─ Syndrome bit for each processed check indicating if check is valid or no !

ROM Graph memory 1 (stores code's graph structure) — 6
$\forall c \in C, N(c)$

Convergence testing block: Check if $s_{sign} = 0$ for M consecutive checks ? — 8

9

Success / Failure

EP 1 610 466 A1

# FIG 16

N=24, M=12, Z=4

P' denotes a Z Z identity matrix right shifted tunes

$$P0=\begin{bmatrix} 1 & & & \\ & 1 & & \\ & & 1 & \\ & & & 1 \end{bmatrix} \quad P1=\begin{bmatrix} & 1 & & \\ & & 1 & \\ & & & 1 \\ 1 & & & \end{bmatrix} \quad P2=\begin{bmatrix} & & 1 & \\ & & & 1 \\ 1 & & & \\ & 1 & & \end{bmatrix} \quad P3=\begin{bmatrix} & & & 1 \\ 1 & & & \\ & 1 & & \\ & & 1 & \end{bmatrix}$$

Before permutation:

$$H=\begin{bmatrix} P0 & & P0 & P0 & & \\ & P0 & & P0 & & P0 \\ P0 & & & & P0 & P0 \end{bmatrix} \updownarrow M/Z$$

After permutation:

$$H=\begin{bmatrix} P1 & & P3 & P1 & & \\ & P2 & & P2 & & P0 \\ P0 & & & & P3 & P1 \end{bmatrix} \updownarrow M/Z$$

# FIG 17

first embodiment

R-RAM
for $R_{cv}$ messages    7

B/Z

bpm

R-RAMs is accessed
sequentially (using
an address counter)

$\cdots$

$\updownarrow$ bpm

5-1    $\cdots$    5-

CONTROLLER    8

9

(bpm+1)

4

$\cdots$

read and permute/
permute and write

permutation

$\cdots$

2

N/Z

$Z^*$(bpm+1)

Q-RAM
for $Q_v$ messages    3

N/Z

10

Address
ROM    6

B/Z

$Ceil(\log_2(N/Z)) + Ceil(\log_2(Z))$

# FIG 18

first embodiment (implementation)

R-RAM (R-RAMs is accessed sequentially using an address counter)

$E/Z = 9$

bpm

$(bpm+1)$

CONTROLLER 8 9

4

read and permute/
Q-RAM  permute and write        permutation

2

| $Q_1$ | $Q_2$ | $Q_3$ | $Q_4$ |
|---|---|---|---|
| $Q_5$ | $Q_6$ | $Q_7$ | $Q_8$ |
| $Q_9$ | $Q_{10}$ | $Q_{11}$ | $Q_{12}$ |
| $Q_{13}$ | $Q_{14}$ | $Q_{15}$ | $Q_{16}$ |
| $Q_{17}$ | $Q_{18}$ | $Q_{19}$ | $Q_{20}$ |
| $Q_{21}$ | $Q_{22}$ | $Q_{23}$ | $Q_{24}$ |

$N/Z = 6$   3

10

Address ROM   6

| Address | Shift |
|---|---|
| 0 | 1 |
| 2 | 3 |
| 3 | 1 |
| 1 | 2 |
| 3 | 2 |
| 5 | 0 |
| 0 | 0 |
| 4 | 3 |
| 5 | 1 |

$E/Z = 9$

M/N: parity check matrix dimensions
E: number of 1's in the parity check
   matrix
Z: parallelism factor
N: 24.M   12.E   36.Z   4

$$H = \begin{bmatrix} p^1 & & p^3 & p^1 & & \\ & p^2 & & p^2 & & p^0 \\ p^0 & & & & p^3 & p^1 \end{bmatrix}$$

$\mathrm{Ceil}(\log_2(N/Z)) + \mathrm{Ceil}(\log_2(Z)) = 3 + 2 = 5$

## FIG 19

Generalized check node processor 5-i

$\{v_1, v_2, ..., v_d\} \in N(c)$
$d_c$ – the degree of check node c

Inputs (left): $Qv_1$, $Qv_2$, $Qv_{dc}$, $Rcv_1$, $Rcv_2$, $Rcv_{dc}$

5-i

Check node processor

Outputs (right): $Qv_1$, $Qv_2$, $Qv_{dc}$, $Rcv_1$, $Rcv_2$, $Rcv_{dc}$, $S_{sign}$

EP 1 610 466 A1

# FIG 20 *first embodiment*

Check node processor $\underline{5}$

Node degree $d_C$
{control signal-
according to code rate}

from 3
$Q_v$

from 7
$R_{cv}$

bpm+1,
2's comp

bpm,
2's comp

Check Saturation
$Qv = +/-2 \wedge bpm)$

Disable Q,R
message update
(control signal
carried with the pipe)

$Q_v$   $R_{cv}$

+   −
subtract

The Transform also
performs conversion
*from 2's complement*
to sign/magnitude

$\varphi$

sign/mag

Choose 000000
once every $d_C$
clocks

000000

$Q_{temp}$   $\varphi(Q_{temp})$

Programmable
delay line of
length $d_C$

$Q_{temp}$   $\varphi(Q_{temp})$

+   +
add & xor

$S_{temp}$

$Q_{temp}$   $\varphi(Q_{temp})$

S   Enable once
every $d_C$ clocks

−   +
subtract
& xor

$Q_{temp}$   $S-\varphi(Q_{temp})$

$\varphi^{-1}$   The Transform
also performs
conversion from
sign/magnitude to
2's complement

2's comp

add

$Q_{v\,new}$   $R_{cv\,new}$

bpm+1,
2's comp

bpm,
2's comp

$Q_{v,new}$   $R_{cv,\,new}$

1   $\underline{5-i}$

$S_{ingr}$
To convergence testing
*block (sampled every $d_C$
clocks)* $\underline{8}$

# FIG 21

second embodiment

M x N - parity-check matrix dimensions
dc - parity-check matrix row degree (check node degree)
Z - parallelism factor

FIG 22

second embodiment

BP check node processor

bpm-bits per message

5-i

QR block 1
5a-d_c

$R_{CV}$  $\varphi(Q_V-R_{CV})$   S

from R-RAM   bpm

$Q_V$

from Q-RAM   bpm-1

$R_{CV, new}$   bpm   to R-RAM

$Q_{V, new}$   bpm-1   to Q-RAM

QR block 1
5a-1

$R_{CV}$  $\varphi(Q_V-R_{CV})$   S

from R-RAM   bpm

$Q_V$

from Q-RAM   bpm+1

$R_{CV, new}$   bpm   to R-RAM

$Q_{V, new}$   bpm+1   to Q-RAM

QR block_1-in   QR block_{dv}-in

S block
5b

$S_{shift}$   S

# FIG 23    second embodiment

QR-Block    $Q_V$    $R_{CV}$    bpm-bits per message

bpm+1,
2's comp    bpm,
2's comp    5a-i

Check Saturation
$Qv = +/-2 \wedge bpm)$    $Q_V$    $R_{CV}$

The Transform also
performs conversion
from 2's complement
to sign/magnitude

Disable Q,R block
(control signal
carried with the pipe)    subtract

$\varphi$

sign/mag

$Q_{temp}$    $\varphi(Q_{temp})$

$\varphi(Q_{temp})$

$Q_{temp}$    $\varphi(Q_{temp})$

S

$Q_{temp}$    $\varphi(Q_{temp})$    S    Merge Row
Control
(enable 1 or 2
clocks according
to code Rate R)

subtract & xor

$Q_{temp}$    $S-\varphi(Q_{temp})$

$\varphi^{-1}$    The Transform
also performs
conversion from
sign/magnitude to
2's complement

2's comp

add

$Q_{V,new}$    $R_{CV,new}$

bpm+1,
2's comp    bpm,
2's comp

$Q_{V,new}$    $R_{CV,new}$

# FIG 24

second embodiment

# FIG 25

Convergence testing block

# FIG 26

$$M = M_1 + M_2$$

A

B

P'
P'
P''
P''

0

T

$$T = \begin{bmatrix} P1 & P0 & & & \\ 0 & P0 & P0 & & 0 \\ \vdots & & P0 & \ddots & \\ 0 & & & \ddots & P0 \\ P0 & & & & \\ 0 & & & & \\ \vdots & & 0 & P0 & P0 \\ 0 & & & & P0 \\ P1 & & & & \end{bmatrix}$$

# FIG 27

N - codeword length
K - information length

2B

Initialized with K
information bits

XOR trees/
switch  XOR accumulators

10B

codeword b

RAM
(size: N bits)

3

P1

P2

⋮

Pz

4

5

ROM

Graph memory 1
(stores code's graph
structure)
$\forall c \in C, N(c)$

6

1B

**European Patent Office**

# EUROPEAN SEARCH REPORT

Application Number

EP 05 01 2044

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | MANSOUR M M ET AL: "High-throughput LDPC decoders" IEEE TRANSACTIONS ON VERY LARGE SCALE INTEGRATION (VLSI) SYSTEMS, IEEE INC. NEW YORK, US, vol. 11, no. 6, December 2003 (2003-12), pages 976-996, XP002302866 ISSN: 1063-8210 * the whole document * | 1-29 | H03M13/11 H04L1/00 |
| P,X | HOCEVAR D E: "A Reduced Complexity Decoder Architecture via Layered Decoding of LDPC Codes" SIGNAL PROCESSING SYSTEMS, 2004. SIPS 2004. IEEE WORKSHOP ON AUSTIN, TEXAS, USA 13-15 OCT. 2004, PISCATAWAY, NJ, USA,IEEE, 13 October 2004 (2004-10-13), pages 107-112, XP010743944 ISBN: 0-7803-8504-7 * the whole document * | 1-29 | |
| P,X | E. SHARON, S. LITSYN, J. GOLDBERGER: "An efficient message-passing schedule for ldpc decoding" 23RD IEEE CONVENTION OF ELECTRICAL AND ELECTRONICS ENGINEERS IN ISRAEL, 6 September 2004 (2004-09-06), pages 223-226, XP002348730 * the whole document * | 1-29 | TECHNICAL FIELDS SEARCHED (Int.Cl.7) H03M H04L |

-/--

The present search report has been drawn up for all claims

| Place of search | Date of completion of the search | Examiner |
|---|---|---|
| The Hague | 12 October 2005 | Van Staveren, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 1 610 466 A1**

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | KSCHISCHANG F R ET AL: "INTERATIVE DECODING OF COMPOUND CODES BY PROBABILITY PROPAGATION INGRAPHICAL MODELS" IEEE JOURNAL ON SELECTED AREAS IN COMMUNICATIONS, IEEE INC. NEW YORK, US, vol. 16, no. 2, February 1998 (1998-02), pages 219-230, XP000741776 ISSN: 0733-8716 * the whole document * ----- | 1,11 | |
| A | H. KFIR, I. KANTER: "Parallel versus sequential updating for belief propagation decoding" PHYSICA A, 1 December 2003 (2003-12-01), pages 259-270, XP002348768 * the whole document * ----- | 1-29 | |
| A | J. ZHANG, M. FOSSORIER: "Shuffled belief propagation decoding" CONFERENCE RECORD OF THIRTY-SIXTH ASILOMAR CONFERENCE ON SIGNALS, SYSTEMS AND COMPUTERS, 3 November 2002 (2002-11-03), - 6 November 2002 (2002-11-06) pages 8-15, XP002348769 * the whole document * ----- | | TECHNICAL FIELDS SEARCHED (Int.Cl.7) |

The present search report has been drawn up for all claims

| Place of search | Date of completion of the search | Examiner |
|---|---|---|
| The Hague | 12 October 2005 | Van Staveren, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)